(19) Europäisches Patentamt
European Patent Office
Office européen des brevets

(11) EP 4 435 857 A1

(12) # EUROPEAN PATENT APPLICATION

(43) Date of publication:
**25.09.2024 Bulletin 2024/39**

(21) Application number: **24165478.9**

(22) Date of filing: **22.03.2024**

(51) International Patent Classification (IPC):
***H01L 25/075*** (2006.01) ***H01L 33/52*** (2010.01)
***H01L 33/54*** (2010.01) ***H01L 33/58*** (2010.01)

(52) Cooperative Patent Classification (CPC):
**H01L 25/0753; H01L 33/52; H01L 33/54; H01L 33/58**

(84) Designated Contracting States:
**AL AT BE BG CH CY CZ DE DK EE ES FI FR GB GR HR HU IE IS IT LI LT LU LV MC ME MK MT NL NO PL PT RO RS SE SI SK SM TR**
Designated Extension States:
**BA**
Designated Validation States:
**GE KH MA MD TN**

(30) Priority: **23.03.2023 US 202363454268 P**
**17.02.2024 TW 113105614**

(71) Applicant: **Yenrich Technology Corporation**
**Hsinchu County 308 (TW)**

(72) Inventors:
- **Chang, Ya-Hsien**
**308 Baoshan Township, Hsinchu County (TW)**
- **Hu, Wei-Chiang**
**308 Baoshan Township, Hsinchu County (TW)**
- **Ko, Bo-Yu**
**308 Baoshan Township, Hsinchu County (TW)**
- **Chang, Chieh-Chun**
**308 Baoshan Township, Hsinchu County (TW)**
- **Lin, Tzu-Yuan**
**308 Baoshan Township, Hsinchu County (TW)**
- **Chen, Ching-Yi**
**308 Baoshan Township, Hsinchu County (TW)**

(74) Representative: **Ter Meer Steinmeister & Partner**
**Patentanwälte mbB**
**Nymphenburger Straße 4**
**80335 München (DE)**

(54) **LIGHT-EMITTING MODULE**

(57) A light-emitting module is provided. The light-emitting module includes a substrate and n number of light-emitting elements disposed on the substrate. The n number of light-emitting elements have n-1 number of first intervals. The n-1 number of first intervals have a first standard deviation, wherein n is greater than or equal to 3. The light-emitting module further includes a light-shielding structure which is disposed on the n number of light-emitting elements and has n number of light-emitting holes. The n number of light-emitting holes correspond to the n number of light-emitting elements, respectively, and have n-1 number of second intervals. The n-1 number of second intervals have a second standard deviation, wherein the first standard deviation is greater than the second standard deviation.

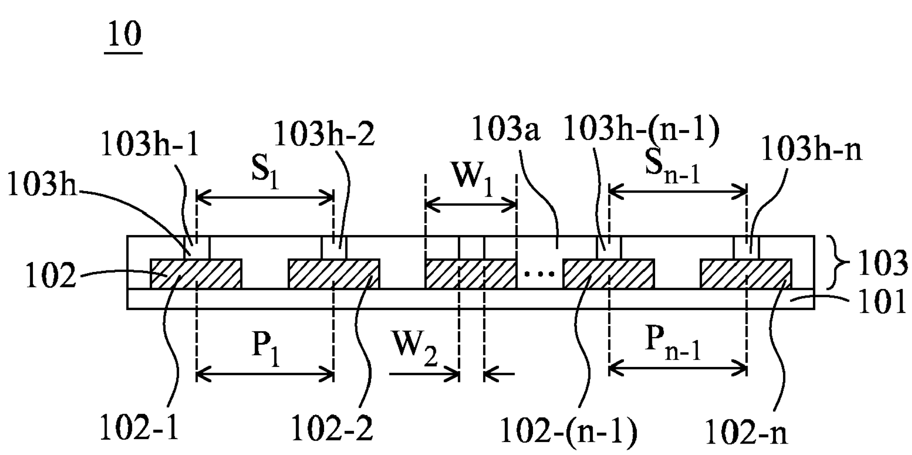


FIG. 8



Processed by Luminess, 75001 PARIS (FR)

## Description

TECHNICAL FIELD

The present disclosure relates to a light-emitting module, and in particular to a light-emitting module used in image output devices.

This application claims the benefit of TW Application No. 113105614, filed on February 17, 2024, and U.S. Provisional Application No. 63/454,268, filed on March 23, 2023.

BACKGROUND

Description of the Related Art

Light-emitting diodes (LEDs) have the advantages of low power consumption, long component life, having no need for warm-up time, and having a fast response speed. In addition, light-emitting diodes are small in size and resistant to vibration that are suitable for mass production. They can easily be made into extremely small or array-type modules to meet application requirements, and are widely used in the market. For example, an array-type light-emitting diode module can form a photosensitive array in an image output device (e.g., a camera or a photocopier).

As the requirements for image resolution continue to increase, the accuracy of the light-emitting position of each light-emitting element in the photosensitive array has become important. However, many limitations in the existing technology often make it difficult for the light-emitting position of the light-emitting element to meet expectations, which affects the resolution of the photosensitive arrays. Light-emitting elements, such as light-emitting diodes (LEDs), are usually mounted on a printed circuit board (PCB) with surface-mount technology (SMT). Generally, surface mount technology often includes a reflow process, but the light-emitting elements often deviate from their original positions during the reflow process easily, resulting in the light-emitting position of the light-emitting elements in the product failing to meet product specifications. Therefore, it is necessary to improve the light-emitting module and the method of manufacturing the same for producing a photosensitive device that meets product requirements.

BRIEF DESCRIPTION OF THE DRAWINGS

The object is solved by the features of the independent claims. Preferred embodiments are given in the dependent claims.

According to an aspect of the invention a light-emitting module is provided, comprising: a substrate; n number of light-emitting elements disposed on the substrate and having n-1 number of first intervals, wherein the n-1 number of first intervals have a first standard deviation, any one of the n-1 number of first intervals is a horizontal distance between two adjacent light-emitting elements among the n number of light-emitting elements, and n is greater than or equal to 3; and a light-shielding structure disposed on the n number of light-emitting elements and having n number of light-emitting holes, wherein each of the n number of light-emitting holes corresponds to each of the n number of light-emitting elements, the n number of light-emitting elements have n-1 number of second intervals, the n-1 number of second intervals have a second standard deviation, and any one of the n-1 number of second intervals is a horizontal distance between two adjacent light-emitting holes of the n number of light-emitting holes, wherein the first standard deviation is greater than the second standard deviation.

In one or more embodiments, the light-shielding structure may comprise a barrier layer disposed between the n number of light-emitting elements; and a light-shielding layer disposed above the barrier layer.

In one or more embodiments, the light-shielding structure may further comprise an interposer layer disposed between the barrier layer and the light-shielding layer.

In one or more embodiments, the light-shielding structure may have a concave portion.

In one or more embodiments, the concave portion may recess downwardly between the two adjacent light-emitting elements.

In one or more embodiments, the light-emitting module may further comprise a transparent substrate disposed on the light-shielding structure.

In one or more embodiments, the transparent substrate may comprise a plurality of optical microstructures disposed above the n number of light-emitting elements.

In one or more embodiments, the light-emitting module may further comprise a transparent substrate disposed on the light-shielding structure.

In one or more embodiments, the transparent substrate may comprise a lens below a lower surface of the transparent substrate and protruding toward at least one of the n number of light-emitting elements.

In one or more embodiments, the light-emitting module may further comprise a wavelength conversion layer disposed within at least one of the light-emitting holes.

In one or more embodiments, the light-emitting module may further comprise a protective layer disposed above the light-shielding structure.

In one or more embodiments, in a cross-sectional view, each of the two adjacent light-emitting elements may have a vertical center line, and the horizontal distance between the two adjacent light-emitting elements is the horizontal distance between two vertical center lines.

In one or more embodiments, a width of any one of the n number of light-emitting holes may be smaller than a width of any one of the n number of light-emitting elements.

Aspects of the present disclosure are better understood from the following detailed description when read with the accompanying figures. It is worth noting that some features may not be drawn to scale in accordance with the standard practice in the industry. In fact, the dimensions of the various features may be arbitrarily increased or reduced for clarity of discussion.

FIG. 1A is a perspective view of a photosensitive printer of the embodiments of the disclosure.

FIG. 1B is an exploded view of a photosensitive printer of the embodiments of the disclosure.

FIG. 1C is a schematic diagram illustrating the configuration of a light-emitting array and photosensitive paper according to the embodiments of the present disclosure.

FIG. 2A is a top view illustrating a light-emitting module of the embodiments of the disclosure.

FIGS. 2B-2E are schematic diagrams illustrating the development process of the light-emitting module according to the embodiments of the present disclosure.

FIG. 3 is a cross-sectional view along line AA in FIG. 2C.

FIGS. 4A and 4B are schematic diagrams illustrating the configuration of a light-emitting module and photosensitive paper according to the embodiments of the present disclosure.

FIGS. 5-8 are cross-sectional views illustrating several intermediate structures during the manufacturing process of the light-emitting module of the embodiments of the present disclosure.

FIG. 9 is a cross-sectional view illustrating an intermediate structure during the manufacturing process of the light-emitting module according to the embodiments of the present disclosure.

FIGS. 10-12 illustrate the cross-sectional views of light-emitting modules according to other embodiments of the present disclosure.

FIG. 13 illustrates a cross-sectional view of a light-emitting module with a concave barrier layer according to another embodiment of the present disclosure.

FIG. 14 illustrates a cross-sectional view of a light-emitting module with a light-shielding structure according to another embodiment of the present disclosure.

FIGS. 15A, 15B, 16, and 17 respectively illustrate cross-sectional views of light-emitting modules with interposers according to other embodiments of the present disclosure.

FIGS. 18 and 19 respectively illustrate cross-sectional views of light-emitting modules with transparent base materials according to other embodiments of the present disclosure.

FIG. 20 is an enlarged view of the area enclosed by the dotted line in FIG. 19.

FIGS. 21 and 22 respectively illustrate cross-sectional views of light-emitting modules with wavelength conversion layers according to other embodiments of the present disclosure.

FIGS. 23 and 24 respectively illustrate cross-sectional views of a light-emitting module with a protective layer according to another embodiment of the present disclosure.

FIG. 25 illustrates a cross-sectional view of a light-emitting module with a wear-resistant layer according to another embodiment of the present disclosure.

FIG. 26 illustrates a cross-sectional view of a light-emitting module with other light-shielding structures according to other embodiments of the present disclosure.

FIG. 27 illustrates a cross-sectional view of a light-emitting module with other light-shielding structures according to other embodiments of the present disclosure.

FIGS. 28-38 respectively illustrate cross-sectional views of light-emitting modules with other light-shielding structures according to other embodiments of the present disclosure.

DETAILED DESCRIPTION

The following disclosure provides many different embodiments, or examples, for implementing different features of the provided quantum dot composite structures. Specific examples of components and arrangements are described below to simplify the present disclosure. These are, of course, merely examples and are not intended to be limiting. For example, the formation of a first feature over or on a second feature in the description that follows may include embodiments in which the first and second features are formed in direct contact, and may also include embodiments in which additional features may be formed between the first and second features, such that the first and second features may not be in direct contact. In addition, the disclosure may repeat symbols and/or characters of components in different embodiments or examples. This repetition is for simplicity and clarity, rather than to represent the relationship between the different embodiments and/or examples discussed.

Furthermore, spatially relative terms, such as "beneath," "below," "lower," "on," "above," "upper" and the like, may be used herein for ease of description to describe one element or feature's relationship to other elements or features as illustrated in the figures. The spatially relative terms are intended to encompass different orientations of the device in use or operation in addition to the orientation depicted in the figures. The apparatus may be otherwise oriented (rotated 90 degrees or at other orientations) and the spatially relative descriptors used herein may likewise be interpreted accordingly.

In the present disclosure, the terms "about," "approximately" and "substantially" typically mean +/-20% of the stated value, more typically +/-10% of the stated value, more typically +/-5% of the stated value, more typically +/-3% of the stated value, more typically +/-2% of the stated value, more typically +/-1% of the stated value and even more typically +/-0.5% of the stated value. The stated value of the present disclosure is an approximate value. That is when there is no specific description of the terms "about," "approximately" and "substantially", the stated value includes the meaning of "about," "approximately" or "substantially".

In some embodiments of the present disclosure, terms related to disposing and connecting, such as "dispose", "connect", and the like, unless specifically defined, may refer that two components are in direct contact, or may also refer that two components are not in direct contact wherein another component is disposed between the two structures. The terms related to disposing and connecting may also include the embodiments where both components are movable or both components are fixed.

Unless otherwise defined, all terms (including technical and scientific terms) used herein have the same meaning as commonly understood by one of ordinary skill in the art to which this disclosure belongs. It should be understood that terms such as those defined in commonly used dictionaries should be interpreted as having a meaning that is consistent with their meaning in the context of the relevant art and will not be interpreted in an idealized or overly formal sense unless expressly so defined in the embodiments of the present disclosure.

Some modifications of the embodiment are described below. In the different drawings and illustrated embodiments, similar reference numerals are used to designate similar features. It should be understood that additional operations may be provided before, during, and after the method, and some of the operations that are described may be deleted or replaced with other embodiments of the method.

Embodiments of the present disclosure provide a light-emitting module. The light-emitting module includes a substrate and a plurality of light-emitting elements disposed thereon. Each light-emitting element has an opening defined by a light-shielding structure. Since the openings are formed through precise processes, such as photolithography and etching, the light-emitting position of each light-emitting element can be more accurately controlled to meet higher product design specifications.

FIG. 1A illustrates that the photosensitive printer 1 can form an image on a photosensitive paper 200. FIG. 1B illustrates an exploded view of the photosensitive printer 1, wherein the photosensitive printer 1 has a light-emitting module 10A for emitting light of different wavelengths on the photosensitive paper 200 so that the photosensitive paper 200 can present colorful images. FIG. 1C illustrates a schematic diagram of the configuration of the light-emitting module 10A and the photosensitive paper 200 according to an embodiment, wherein the light-emitting module 10A includes a plurality of light-emitting elements 102 to form a light-emitting array. The light-emitting array includes a red light-emitting array 102R, a green light-emitting array 102G and a blue light-emitting array 102B (the arrangement of the three-color light-emitting arrays is not limited to the order shown in the figure and can be any suitable combination, and namely, there are 6 arrangements in total), wherein the red light-emitting array 102R includes a plurality of red light-emitting elements 102r, the green light-emitting array 102G includes a plurality of green light-emitting elements 102g, and the blue light-emitting array 102B includes a plurality of blue light-emitting elements 102b. The photosensitive paper 200 can move past the print head through the guidance compartments (not shown) of the photosensitive printer 1, and the print head irradiates red light, green light, or blue light at a specific position on the photosensitive paper. The photosensitive material on the photosensitive paper 200 is converted into different colors after being irradiated, and finally, an image of a predetermined color is presented on the photosensitive paper 200.

Referring to FIG. 2A, which is a top view of the light-emitting module 10 according to the embodiments of the present disclosure. The light-emitting module 10 includes a light-shielding structure 103 and a plurality of light-emitting hole groups 103hs, wherein the plurality of light-emitting hole groups 103hs are arranged in a plurality of rows, such as four rows, five rows, six rows, or more. The extension direction of each row is parallel to the Y direction, and two light-emitting hole groups 103hs located in the same column of two adjacent rows of the light-emitting hole groups 103hs are offset by a fixed distance Dh along the Y direction. In other words, there are no two light-emitting hole groups 103hs that completely overlap or partially overlap each other in the X direction. In one embodiment, each light-emitting hole group 103hs includes a plurality of light-emitting holes 103h, such as three, four, or more light-emitting holes 103h, arranged in a straight line along the X direction. In other embodiments, the plurality of light-emitting holes 103h can be arranged in a triangular shape or an L shape. In one embodiment, in each light-emitting hole group 103hs, the plurality of light-emitting holes 103h can respectively emit red light, blue light, green light, or a combination of other color lights. In one embodiment, each row of light-emitting hole groups 103hs includes four, five, six, or more light-emitting hole groups 103hs. In addition, each row of light-emitting hole groups 103hs may include the same or different number of light-emitting hole groups 103hs.

Referring to FIGS. 2B-2E together, which are schematic diagrams illustrating the image output process of the light-emitting module 10 according to an embodiment. FIG. 2B firstly shows the photosensitive paper 200 has a plurality of predetermined exposure areas 200a. In one embodiment, a plurality of predetermined exposure areas 200a are arranged in an array along the X and Y directions. When the photosensitive paper 200 is above the light-emitting module 10 and moves toward the light-emitting module 10 in the X direction (as the direction indicated by the arrow in the figure), the predetermined exposure areas 200a overlapping the light-emitting holes 103h are irradiated, and are exposed by the light emitted from the light-emitting holes 103h. Specifically, further referring to FIG. 2C, when the first row of predetermined exposure areas 200a in the photosensitive paper 200 covers the first row of light-emitting hole groups 103hs, the light emitted from the covered light-emitting hole 103h irradiates the predetermined exposure area 200a to form the exposure areas 35, which are the pixel points of the image formed on the photosensitive paper 200. As illustrated in FIG. 2D and FIG. 2E, as the photosensitive paper 200 moves toward the light-emitting module 10 in the X direction, more predetermined exposure areas 200a on the photosensitive paper 200 are irradiated by light from the light-emitting holes 103h below, and finally forming an image composed of pixels on the photosensitive paper 200. In one embodiment, the light-emitting hole groups 103hs include three light-emitting holes 103h, which respectively emit red light, green light, and blue light, and different colors can be formed by adjusting the light intensity of red light, green light, and blue light or the irradiation time in the predetermined exposure areas 200a.

FIG. 3 is a cross-sectional view taken along line AA in FIG. 2C. To simplify the figures, the distance between two adjacent light-emitting holes 103h and two adjacent light-emitting elements 102 may not be drawn according to scale. As shown in FIG. 3, the photosensitive paper 200 covers the light-emitting module 10. The light-emitting module 10 includes a substrate 101, a plurality of light-emitting elements 102, a light-shielding structure 103, and a plurality of light-emitting holes 103h, wherein the plurality of light-emitting holes 103h respectively correspond to the plurality of light-emitting elements 102. In one embodiment, as shown in FIG. 3, the center line 103hc of the light-emitting holes 103h and the center line 102c of the light-emitting surface of the light-emitting elements 102 may be overlapped or non-overlapped. In one embodiment, the light-emitting elements 102 in FIG. 3 may be the red light-emitting element 102r, the green light-emitting element 102g, or the blue light-emitting element 102b as illustrated in FIG. 1C. The photosensitive paper 200 includes a protective layer 201 and a photosensitive layer 202. The photosensitive layer 202 serves as a photosensitive medium. The protective layer 201 can protect the photosensitive layer 202 by preventing the photosensitive layer 202 from directly contacting other components or environmental media. The protective layer 201 is in contact with the light-shielding structure 103 of the light-emitting module 10 on the contact surface C. The light emitted from the plurality of light-emitting elements 102 can pass through the corresponding light-emitting holes 103h and irradiate the photosensitive layer 202 to form a plurality of exposure areas 35.

As an embodiment illustrated in FIG. 4A, a light-emitting element 102 is disposed below each light-emitting hole 103h, and the plurality of light-emitting elements 102 have the same arrangement as that of the plurality of light-emitting holes 103h. Specifically, any two light-emitting hole groups 103hs in the same column in two adjacent rows are offset by a fixed distance (i.e., have a fixed displacement) in the same direction (i.e., +/-Y direction), and the detailed description is shown in FIG. 2A and related paragraphs. As shown in FIG. 4B, in another embodiment, each light-emitting hole 103h in the light-emitting module 10’ corresponds to a light-emitting element 102, and the plurality of light-emitting elements 102 have the same arrangement with that of the plurality of light-emitting holes 103h. Specifically, among the three light-emitting hole groups 103hs located in the same column in three adjacent rows, the rightmost light-emitting hole groups 103hs and the middle light-emitting hole groups 103hs are offset by different distances (i.e., have different displacement amounts) in the vertical direction (i.e., Y axis) relative to the leftmost light hole group 103hs.

As shown in FIG. 4A and FIG. 4B, the area of the light-emitting hole 103h is smaller than the area of the light-emitting element 102. Therefore, only the portion of the light emitted by the light-emitting element 102 that passes through the light-emitting hole 103h irradiates the photosensitive paper 200. In short, as long as the position of the light-emitting hole 103h of the light-shielding structure 103 can be accurately controlled, even if the light-emitting element 102 and the light-emitting hole 103h are not aligned, as long as the intensity of the light emitted through the light-emitting hole 103h is larger than 1.7 $\mu$W, the exposure of the exposure area 200a of the photosensitive paper 200 can be maintained.

Now, embodiments of the present disclosure and some modifications are described in more detail with reference to the figures. For the sake of simplicity, the photosensitive paper 200 is not presented in all figures below. However, unless otherwise specified, the following light-emitting modules are in contact with the protective layer 201 of the photosensitive paper 200 on the contact surface C.

Referring to FIGS. 5-8, which respectively illustrate cross-sectional schematic diagrams of each stage in the manufacturing process of the light-emitting module 10 as shown in FIG. 3 according to some embodiment of the present disclosure. As shown in FIG. 5, a substrate 101 is provided. In one embodiment, substrate 101 can be materials with sufficient rigidity like a sapphire substrate, a silicon substrate, a glass substrate, a printed circuit board (PCB), a metal substrate, a ceramic substrate, or a combination thereof, but the disclosure is not limited thereto. In this embodiment, the substrate 101 is a printed circuit board.

As shown in FIG. 6, a light-emitting array including n number of light-emitting elements 102 in each row is provided on substrate 101, where n is any positive integer, for example, n is a positive integer greater than or equal to 2. For example, in one embodiment, the light-emitting element 102 can be disposed on substrate 101 through surface-mount technology (SMT). In one embodiment, the light-emitting element 102 includes a vertical chip, a horizontal chip, or a flip chip.

In one embodiment, the light-emitting element 102 is a light-emitting diode chip, which can emit blue light or UV light. In one embodiment, the light-emitting element 102 has a maximum width ranging from 1 $\mu$m to 10 $\mu$m, from 10 $\mu$m to 100 $\mu$m, from 100 $\mu$m to 500 $\mu$m, or from 500 $\mu$m to 1000 $\mu$m.

As shown in FIG. 7, a barrier layer 103a covers the light-emitting element 102. In one embodiment, the barrier layer 103a is formed around each light-emitting element 102. In other words, the barrier layer 103a surrounds the periphery of the light-emitting array and is disposed between any two adjacent light-emitting elements 102.

In one embodiment, the barrier layer 103a may include a transparent adhesive material and a reflective or scattering material dispersed therein, which may reflect or scatter the light (for example, blue light) emitted by the light-emitting element 102 to reduce the mutual interference of the light emitted by the light-emitting element 102. In one embodiment, the reflective or scattering material includes, for example, titanium dioxide ($TiO_2$) or silicon oxide (SiOx), and the transparent adhesive material includes, for example, silicone or epoxy. In another embodiment, the barrier layer 103a may include a light-absorbing material and a transparent adhesive material, which may absorb the light (e.g., blue light) emitted by the light-emitting elements 102 to reduce mutual interference of the light emitted by the light-emitting elements 102.

As shown in FIG. 8, n number of light-emitting holes 103h are formed on the barrier layer 103a to form the light-shielding structure 103, wherein each of the light-emitting holes 103h corresponds to each of the light-emitting elements 102. In one embodiment, photolithography and etching processes may be used to form the light-emitting holes 103h on the barrier layer 103a. In one embodiment, the etching process may include a dry etching process or a wet etching process. In other embodiments, laser drilling process may also be used to form the light-emitting hole 103h on the barrier layer 103a. In one embodiment, a planarization process, such as a chemical mechanical polishing (CMP) process, may be performed after forming the light-emitting hole 103h to planarize the surface of the barrier layer 103a.

The light-emitting hole 103h is used to define the light-emitting position of the light-emitting elements 102. In one embodiment, the width $W_2$ of the light-emitting hole 103h is smaller than the width $W_1$ of the light-emitting element 102 there below to limit the light-emitting position of the light-emitting element 102. Specifically, in one embodiment, the ratio ($W_1/W_2$) between the width $W_1$ of the light-emitting element 102 and the width $W_2$ of the light-emitting hole 103h may range from 2 to 500. For example, the width $W_1$ of the light-emitting element 102 may range from 5 $\mu$m to 500 $\mu$m, and the width $W_2$ of the light-emitting hole 103h may range from 1 $\mu$m to 100 $\mu$m. In one embodiment, in a top view, the shape of the light-emitting holes 103h may be polygonal, circular, or elliptical (not shown), but the disclosure is not limited thereto.

Still referring to FIG. 8. In one embodiment, the process accuracies of photolithography and etching processes and the laser drilling process used to form the light-emitting hole 103h are better than that of the surface adhesion process used to fix the light-emitting element 102. Therefore, the position of the light-emitting hole 103h can be defined more accurately, so that the light emitted by the light-emitting element 102 can hit the predetermined exposure area 200a of the photosensitive paper 200 more accurately.

Specifically, as shown in FIG. 8, the light-emitting module 10 includes n number of light-emitting elements 102 (from left to right are the first light-emitting element 102-1, the second light-emitting element 102-2... the n-th light-emitting element 102-n). The n number of light-emitting elements 102 have a total of n-1 number of first intervals $P_i$, where $1 \leqq i \leqq n-1$ and i is a positive integer. The first interval $P_i$ is defined as the horizontal distance between the vertical center lines of two adjacent light-emitting elements 102. For example, the first interval $P_1$ is located between the vertical centerline of the first light-emitting element 102-1 and the vertical centerline of the second light-emitting element 102-2, and the first interval $P_{n-1}$ is located between the vertical center line of the n-1th light-emitting element 102-(n-1) and the vertical center line of the n-th light-emitting element 102-n. Similarly, the light-emitting module 10 includes n number of light-emitting holes 103h (from left to right are the first light-emitting hole 103h-1, the second light-emitting hole 103h-2...the n-th light-emitting hole 103h-n). The n number of light-emitting holes 103h have n-1 number of second intervals $S_i$, where $1 \leqq i \leqq n-1$ and i is a positive integer, for example, the second interval $S_1$ is located between the vertical centerline of the first light-emitting hole 103h-1 and the vertical centerline of the second light-emitting hole 103h-2, and the second interval $S_{n-1}$ is located between the vertical center line of the n-1th light-emitting hole 103h-(n-1) and the vertical centerline of the nth light-emitting hole 103h-n. In one embodiment, the process accuracies of photolithography and etching processes used to form the light-emitting holes 103h are better than that of the surface adhesive process of disposing the light-emitting element 102. Therefore, in some embodiment, providing that n≧3, the first standard deviation SD1 of the n-1 first intervals $P_i$ of the light-emitting elements 102 is greater than the second standard deviation SD2 of the n-1 second intervals $S_i$ of the light-emitting holes 103h. (i.e., SD1>SD2).

Referring to Table 1, the light-emitting module disclosed according to one embodiment is expected to have a row of 11 light-emitting elements 102 disposed on the substrate 101. The horizontal distance between the vertical center lines of two adjacent light-emitting elements 102 is approximately 250 μm. Each light-emitting element 102 is provided with a light-emitting hole 103h. The horizontal distance between the vertical center lines of two adjacent light-emitting holes 103h is approximately 250 μm. Referring to FIGS. 6-8 and related paragraphs, the measurement results of the first interval $P_i$ between any two adjacent light-emitting elements 102 and the second interval $S_i$ between any two light-emitting holes 103h in the light-emitting module are shown. The "#n_#n+1" in Table 1 refers to "between the n-th light-emitting element 102-n and the n+1-th light-emitting element 102-(n+1)", for example, the "#1_#2" in Table 1 refers to "between the first light-emitting element 102-1 and the second light-emitting element 102-2". In addition, the units used in Table 1 are all micrometers (μm).

Table 1

| Location | first interval $P_i$ | second interval $S_i$ |
|---|---|---|
| #1_#2 | 250.861 | 250 023 |
| #2_#3 | 249.004 | 250 255 |
| #3_#4 | 249.724 | 250 167 |
| #4_#5 | 250.709 | 249 987 |
| #5_#6 | 250.878 | 249 962 |
| #6_#7 | 247.571 | 250 312 |
| #7_#8 | 251.799 | 250 112 |
| #8_#9 | 252.462 | 250 053 |
| #9_#10 | 249.075 | 250 122 |
| #10_#11 | 249.135 | 250 076 |
| Standard Deviation | SD1 = 1.405 | SD2 = 0.107 |

It can be seen from Table 1 that the second standard deviation SD2 of the second interval S is smaller than the first standard deviation SD1 of the first interval P in some embodiments.

The first standard deviation SD1 is defined as follows:

$$\mathrm{SD1} = \sqrt{\frac{1}{n-1}\sum_{i=1}^{n-1}(P_i - \underline{P})^2}$$

wherein, $P_i$ is the first interval between the i-th and i+1-th light-emitting elements 102, and $\underline{P}$ is the average value of n-1 first intervals.

The second standard deviation SD2 is defined as follows:

$$\mathrm{SD2} = \sqrt{\frac{1}{n-1}\sum_{i=1}^{n-1}(S_i - \underline{S})^2}$$

wherein, $S_i$ is the first interval between the i-th light-emitting element 102-i and the i+1-th light-emitting element 102-(i+1), and $\underline{S}$ is the average value of n-1 first intervals.

FIG. 9 illustrates a cross-sectional view of a light-emitting module 10B according to another embodiment of the present disclosure. Each light-emitting element 102 in the light-emitting module 10B corresponds to a plurality of light holes 103h. The plurality of light-emitting holes 103h can be arranged in a straight line, a triangle, a quadrilateral, a polygon with five or more sides, or an L shape according to the number of the plurality of light holes 103h. In FIG. 9, the photosensitive paper 200 is not shown for the sake of simplicity, but it should be understood that the light-emitting module is in contact with the photosensitive paper 200 on the contact surface C.

FIGS. 10-12 respectively illustrate cross-sectional views of light-emitting modules according to other embodiments of the present disclosure. In these figures, the photosensitive paper 200 is not shown in FIG. 11 and FIG. 12 for the sake of simplicity. As the light-emitting module 10C illustrated in FIG. 10, the barrier layer 103a of the light-shielding structure 103 covers all the light-emitting elements 102. The light-shielding layer 103b is formed on the barrier layer 103a. The light-shielding layer 103b has a plurality of light-emitting holes 103h, and each light-emitting hole 103h corresponds to a light-emitting element 102. In another embodiment, a plurality of light-emitting holes 103h correspond to one light-emitting element 102 (not shown). According to an embodiment, the light-shielding structure 103 of the light-emitting module 10C may be first covered with the barrier layer 103a to cover the light-emitting element 102. According to requirements, the surface 103S of barrier layer 103a is planarized by methods such as chemical mechanical polishing or grinding, and the surface 103S of barrier layer 103a is adjusted to a specific height. Then, a light-shielding layer 103b is formed on the surface 103S of the barrier layer 103a. The light-shielding layer 103b has a plurality of light-emitting holes 103h, wherein the plurality of light-emitting holes 103h are formed through photolithography and etching, but the disclosure is not limited thereto.

In one embodiment, the barrier layer 103a includes a transparent material to isolate moisture and oxygen to protect the light-emitting element 102. The transparent material includes silicone or epoxy, but this disclosure is not limited thereto. The light-shielding layer 103b may include a metal material, such as TiW alloy. In one embodiment, the light-shielding layer 103b may include a material that prevents light from passing through, such as a black photoresist material. In one embodiment, the light-shielding layer 103b may include a reflective multi-layer film, such as a distributed Bragg reflector (DBR).

As further shown in FIG. 10, in one embodiment, since the material of the light-shielding layer 103b is a wear-resistant material, when the light-emitting module 10C and the photosensitive paper 200 are in contact with each other on the contact surface C and move relatively, the light-shielding layer 103b can provide protection and reduce the friction loss caused by the light-shielding layer 103b directly contacting the photosensitive paper 200. In addition, in one embodiment, the light-shielding layer 103b can absorb or reflect light from the light-emitting element 102 to further limit the light-emitting position of the light-emitting element 102. In one embodiment, the light-shielding layer 103b includes a material that blocks the penetration of light, such as TiW alloy and black photoresist. The thickness of the light-shielding layer 103b may range from 10 nm to 1000 μm.

As shown in FIG. 11, in one embodiment, the surface 103S of the barrier layer 103a of the light-emitting module 10D is lower than the light-emitting surface 102t of the light-emitting element 102. For example, the surface 103S is lower than the light-emitting surface 102t by about 0.1 μm to 10 μm. As shown in FIG. 12, in one embodiment, the surface 103S of the barrier layer 103a of the light-emitting module 10E is leveled with the light-emitting surface 102t of the light-emitting element 102.

FIG. 13 illustrates a cross-sectional view of a light-emitting module according to another embodiment of the present disclosure. As shown in FIG. 13, in one embodiment, if the surface 103S of the barrier layer 103a is recessed downwardly toward the substrate 101 at the portion between two adjacent light-emitting elements 102 for some reason, for example, the surface 103S is recessed due to the planarization process. When the light-shielding layer 103b is conformally formed on the surface 103S, the portion of the light-shielding structure 103 between two adjacent light-emitting elements 102 also generates a convex portion (lower surface) recessing toward the substrate 101 or an upper surface that recessing downwardly toward the substrate. The convex portion increases the contact area between the light-shielding layer 103b and the barrier layer 103a so that the light-shielding layer 103b better adheres to the barrier layer 103a.

FIG. 14 illustrates a cross-sectional view of a light-emitting module 10G according to other embodiments. The light-emitting module 10G has a plurality of light-emitting holes 103h penetrating the barrier layer 103a and the light-shielding layer 103b. As shown in FIG. 14, in one embodiment, the light-emitting holes 103h penetrate the light-shielding layer 103b and the barrier layer 103a. The method of forming the light-emitting holes 103h is, for example, if the materials of the barrier layer 103a and the light-shielding layer 103b are different, first use the first etchant to pattern-etch the light-shielding layer 103b to form a light-emitting hole 103h in the light-shielding layer 103b. After the light-emitting holes 103h are formed in the light-shielding layer 103b, the light-shielding layer 103b is used as an etching mask, and a second etchant is used to perform a patterned etching process on the barrier layer 103a so that the light-emitting holes 103h extend into the barrier layer 103a or penetrate the barrier layer 103a to expose the surface 102t of the light-emitting element 102. In one embodiment, the patterning etching process may be a dry etching process, a wet etching process, or a combination thereof. Since the portion of the barrier layer 103a above the light-emitting element 102 is removed, the amount of light emitted by the light-emitting element 102 through the light-emitting holes 103h is increased to increase the brightness of the exposure area 35 formed on the photosensitive paper 200.

FIGS. 15A, 15B, 16, and 17 respectively illustrate cross-sectional views of light-emitting modules according to several embodiments of the present disclosure. Although the figures illustrate that the interposer layer 103c is continuous, the present disclosure is not limited thereto. In some other embodiments, the interposer layer 103c may be a discontinuous structure (not shown). For example, the interposer layer 103c may only be disposed on each light-emitting element 102 in sections without completely covering the barrier layer 103a (not shown).

FIGS. 15A and 15B respectively illustrate the manufacturing process and cross-sectional view of the light-emitting module 10H and the light-emitting module 10H' according to the embodiment of the present disclosure. In one embodiment, an interposer layer 103c can be further provided between the barrier layer 103a and the light-shielding layer 103b. For example, the light-shielding layer 103b and the interposer layer 103c can be made into a film set through compression molding, lamination, transfer molding, other suitable methods, or a combination thereof. The film set is then attached to the barrier layer 103a and the top surface of the light-emitting elements 102. In one embodiment, as the light-emitting module 10H shown in FIG. 15A, the light-emitting holes 103h do not have to be filled with the interposer layer 103c. In some other embodiments, such as the light-emitting module 10H' shown in FIG. 15B, the light-emitting holes 103h can also be filled with an interposer layer 103c. For the sake of simplicity, the following embodiments of interposers may only illustrate one of the above-mentioned, and it should be understood that the other type of embodiments is also within the scope of the present disclosure.

In one embodiment, the material of the interposer layer 103c may include a light-transmitting material. In one embodiment, the material of the interposer layer 103c has a transmittance of more than 70% respective to the light emitted by the light-emitting element 102. In one embodiment, the light emitted by the light-emitting elements 102 does not change the wavelength after penetrating the interposer layer 103c. In one embodiment, the material of the interposer layer 103c may include organic materials, such as epoxy resin and silicone. In one embodiment, the material of the interposer layer 103c may include inorganic materials, such as titanium oxide, aluminum oxide, zirconium oxide, silicon oxide, other suitable metal oxides, or a combination thereof. In one embodiment, the thickness of the interposer layer 103c may range from 1 nm to 1 mm.

FIG. 16 illustrates a cross-sectional view of the photosensitive paper 200 and the light-emitting module 10H. In one embodiment, the interposer layer 103c protects the light-emitting element 102 during the contact process between the light-emitting module and the photosensitive paper 200, so that dust, particles, and impurities on the photosensitive paper 200 do not directly contact the light-emitting elements 102.

FIG. 17 illustrates a cross-sectional view of a light-emitting module 10I according to the embodiments of the present disclosure. As shown in FIG. 17, the interposer layer 103c and the light-shielding layer 103b of the light-shielding structure 103 have convex portions facing the substrate 101 between two adjacent light-emitting elements 102. As shown in FIG. 17, the portion of the surface 103S of the barrier layer 103a located between two adjacent light-emitting elements 102 is recessed downward toward the substrate 101, and the interposer layer 103c and the light-shielding layer 103b are conformally formed on the barrier layer 103a. In one embodiment, the light-shielding layer 103b and the interposer layer 103c have a plurality of convex portions that are joined to the concave portions of the barrier layer 103a. Therefore, the contact area between the interposer layer 103c and the barrier layer 103a is increased, allowing it to better adhere to the barrier layer 103a.

FIGS. 18 and 19 respectively illustrate a schematic cross-sectional view and a schematic process diagram of the light-emitting module 10J according to another embodiment, in which the light-emitting module 10J has a transparent substrate 104. Here, for the sake of simplicity, the photosensitive paper 200 is not shown in all figures, but it should be understood that the light-emitting module contacts the photosensitive paper 200 on the contact surface C.

As shown in FIGS. 18 and 19, in one embodiment, the light-emitting module 10J and the light-emitting module 10K have a transparent substrate 104 on the light-shielding layer 103b. As shown in FIG. 18, for example, the transparent substrate 104 can be directly disposed of on the light-shielding layer 103b through film lamination or other suitable process, but the present disclosure is not limited thereto. FIG. 19 illustrates the manufacturing process and cross-sectional view of the light-emitting module 10K. In one embodiment, the interposer layer 103c can first be combined into a film set with the transparent substrate 104, the light-shielding layer 103b, and the interposer layer 103c through compression molding, lamination, or other suitable methods. The film set is then attached to the barrier layer 103a.

In one embodiment, the material of the transparent substrate 104 may be a light-transmitting material. In one embodiment, the material of the transparent substrate 104 may include a material with good light transmittance (for example, the light transmittance is greater than 90%). In one embodiment, the material of the transparent substrate 104 may be selected from polymethyl methacrylate (PMMA), polyethylene terephthalate (PET), polyethylene naphthalate (PEN), polystyrene (PS), polypropylene (PP), polyamide (PA), polycarbonate (PC), polyimide (PI), epoxy resin, silicone, polydimethylsiloxane (PDMS) or a combination thereof.

Referring to FIGS. 18, 19, and 20, wherein FIG.20 is an enlarged view of part A2 of FIG. 19. As shown in FIGS. 18-20, in one embodiment, the transparent substrate 104 includes a plurality of optical microstructures 104a. In one embodiment, the optical microstructure 104a may include a plurality of photonic crystals. The photonic crystals are arranged to correspond to the positions of the light-emitting elements 102 and include a plurality of optical microstructures with specific shapes. The microstructures may guide the light emitted by the light-emitting element 102 toward a specific direction. In one embodiment, the microstructures may be arranged in a specific way according to the light of different wavelengths emitted by the light-emitting elements 102. For example, in one embodiment, the distance D between two adjacent optical microstructures is a fixed value and is an integer multiple of the wavelength L of the light, such as D=L, 2L, 3L, 4L, 5L, but the disclosure is not limited thereto. In an embodiment, the distance D between two adjacent optical microstructures may also be a non-constant value. In one embodiment, the optical microstructure is a straight hole, a tapered hole, or other shaped curved surface (not shown) that is recessed from the upper surface of the transparent substrate 104 away from the substrate 101. In one embodiment, the optical microstructure may also be a cylinder, a cone, or other curved surface (not shown) protruding from the upper surface of the transparent substrate 104 away from the substrate 101.

Referring to FIG. 20, in one embodiment, the transparent substrate 104 may further include a lens structure 104b. The lens structure 104b changes the light pattern of the light emitted by the light-emitting elements 102. In one embodiment, the lens structure 104b and the transparent substrate 104 may be made of the same or different materials. The material of the lens structure 104b may include polymethyl methacrylate (PMMA), polyethylene terephthalate (PET), polycarbonate (PC), or a combination thereof.

In one embodiment, the lens structure 104b may be a convex lens protruding from the lower surface of the transparent substrate 104 close to the substrate 101 toward the light-emitting element 102. In one embodiment, the width of the lens structure 104b may be equal to the width of the light-emitting hole 103h, thereby preventing light from escaping.

FIGS. 21 and 22 respectively illustrate cross-sectional views of light-emitting modules according to other embodiments of the present disclosure.

As shown in FIGS. 21 and 22, in one embodiment, a wavelength conversion layer 105 is provided in the light-emitting holes 103h above the light-emitting elements 102 of the light-emitting module 10L and the light-emitting module 10M respectively. For example, micro jetting or other suitable methods can be used to form the material of the wavelength conversion layer 105 in the light-emitting hole 103h, and a planarization process is then performed to make the top surface 105S of the wavelength conversion layer 105 leveled with the top surface 103bS of the light-shielding layer 103b.

In one embodiment, the wavelength conversion layer 105 may include a transparent material and a wavelength conversion material dispersed in the transparent material. In one embodiment, the transparent material may include transparent resin. For example, the transparent material may be acrylic resin, organosiloxane resin, acrylate-modified polyurethane, acrylate-modified organosilicon resin, epoxy resin, or a combination thereof. In one embodiment, the wavelength conversion material may include quantum dots (QDs) or fluorescent powder to convert the light emitted by the light-emitting element 102 into red light, blue light, green light, yellow light, or light with other suitable wavelengths.

In one embodiment, the red light conversion material may be a red dye, a red quantum dot material, or a red fluorescent powder. For example, the red fluorescent powder can be (Sr, Ca)$AlSiN_3:Eu^{2+}$, $Ca_2Si_5N_8:Eu^{2+}$, $Sr(LiAl_3N_4):Eu^{2+}$, $K_2GeF_6:Mn^{4+}$, $K_2SiF_6:Mn^{4+}$, $K_2TiF_6:Mn^{4+}$ or a combination thereof. In one embodiment, the blue light conversion material may be a blue dye, a blue quantum dot material, or a blue fluorescent powder. In one embodiment, the green light conversion material may be a green dye, green quantum dot material, or green fluorescent powder. For example, the green fluorescent powder can be LuAG fluorescent powder, YAG fluorescent powder, β-SiAlON fluorescent powder, or Silicate fluorescent powder, or a combination thereof. In one embodiment, the yellow light conversion material may be a yellow dye, a yellow quantum dot material, or a yellow fluorescent powder. For example, the yellow light conversion material may be yttrium aluminum garnet (YAG) fluorescent powder.

In one embodiment, the wavelength conversion layer 105 can absorb the first light with a first wavelength emitted by the light-emitting element 102 and convert it into a second light with a second wavelength. In one embodiment, the first wavelength is not equal to the second wavelength. Specifically, in one embodiment, the wavelength conversion layer 105 can be arranged according to the requirements for the color of the light-emitting module and the wavelength of the light emitted by the light-emitting element 102. For example, in one embodiment, when the light-emitting element 102 is an LED chip that emits blue light or ultraviolet light, the wavelength conversion layer 105 may include red fluorescent powder or red quantum dots (QDs) to convert the blue light or ultraviolet light into red light to form a red light-emitting module. In another embodiment, when the light-emitting element 102 is an LED chip that emits blue light or ultraviolet light, the wavelength conversion layer may include green fluorescent powder or green quantum dots to convert the blue light or ultraviolet light into green light. In other embodiments, when the light-emitting element 102 is an LED chip that emits ultraviolet light, the wavelength conversion layer may include blue phosphor or blue quantum dots to convert the ultraviolet light into blue light.

FIGS. 23 and 24 respectively illustrate cross-sectional views of the light-emitting module 10N and the light-emitting module 10O according to the embodiments of the present disclosure. Here, for the sake of simplicity, the photosensitive paper 200 is not shown in FIG. 24, but it should be understood that the light-emitting module contacts the photosensitive paper 200 on the contact surface C. As shown in FIGS. 23 and 24, in one embodiment, the protective layer 106 can be disposed on the light-shielding layer 103b. For example, the protective layer 106 can be disposed on the light-shielding layer 103b through compression molding, lamination, transfer molding, or other suitable methods.

In one embodiment, the material of the protective layer 106 may be a light-transmitting material. In one embodiment, the material of the protective layer 106 can have a transmittance of more than 70% respective to the light emitted by the light-emitting element 102. In one embodiment, the protective layer 106 may be made of silicon oxide (SiOx), silicon nitride (SiNx), polydimethylsiloxane (PDMS), epoxy resin (Epoxy), silicone, combinations or laminates thereof. In one embodiment, the protective layer 106 protects other film layers of the light-emitting module and withstands repeated friction when the light-emitting module is in contact with the photosensitive paper 200. In one embodiment, the protective layer 106 is made of silicon oxide (SiOx) and has a thickness ranging from 1μm to 10μm, or from 10nm to 1000nm. When the protective layer 106 is smaller than 1000 nm, the protective layer 106 is conformally formed on the light-shielding layer 103b and in the light-emitting hole 103h.

FIG. 25 illustrates a cross-sectional view of a light-emitting module 10P according to another embodiment of the present disclosure. As shown in FIG. 25, in one embodiment, a wear-resistant layer 107 is provided on the light-shielding layer 103b. For example, the wear-resistant layer 107 can be disposed on the light-shielding layer 103b by deposition or other suitable methods. In one embodiment, the material of the wear-resistant layer 107 may be metal, such as TiW. In one embodiment, the wear-resistant layer 107 provides protection and withstands repeated friction when the light-emitting module is in contact with the photosensitive paper 200.

FIG. 26 illustrates a cross-sectional view of a light-emitting module 10Q according to another embodiment of the present disclosure. As shown in FIG. 26, in one embodiment, the height of the light-shielding layer 103b is adjusted so that the light-emitting element 102 generates an exposure area 35 of the desired size on the photosensitive paper 200.

Specifically, as shown in FIG. 26, as the height of the light-shielding layer 103b increases, the light-shielding layer 103b absorbs or blocks more light 45 in the light-emitting hole 103h that is not perpendicular to the photosensitive paper 200. In this way, the inconsistency between the width $W_3$ of the exposure area 35 and the width $W_2$ of the light-emitting hole 103h caused by the light 45 that is not perpendicular to the photosensitive paper 200 irradiating the photosensitive paper 200 can be reduced. In one embodiment, the height of the light-shielding layer 103b can be adjusted so that the aspect ratio ($H_1/W_2$) of the light-emitting hole 103h ranges from 0.1 to 10. When the aspect ratio ($H_1/W_2$) of the light-emitting hole 103h is less than 0.1, the exposure area generated by the light-emitting element 102 on the photosensitive paper 200 may be too large. On the contrary, when the aspect ratio ($H_1/W_2$) of the light-emitting hole 103h is greater than 10, the light emitted by the light-emitting element 102 may be absorbed by the light-shielding layer 103b at an excessive rate, so that the light energy irradiated on the exposed area 35 on the photosensitive paper 200 is insufficient, resulting in the color formed on the exposed area 35 being too light.

FIG. 27 illustrates a cross-sectional view of a light-emitting module 10R according to another embodiment of the present disclosure. As shown in FIG. 27, in one embodiment, multiple sets of light-shielding layers 103b can be provided above the light-emitting element 102 to reduce the light 45 that is not vertically irradiated on the photosensitive paper 200. For example, to continue the process as described in FIG. 6, a planarization process can be performed to adjust the height of the barrier layer 103a, and then the first set of light-shielding layers 103bf and the second set of light-shielding layers 103bs and the barrier layer 103a are combined into a film set by compression molding, lamination, transfer molding or other suitable methods. The film set is then attached to the top of the light-emitting element 102.

Referring to FIG. 27, in one embodiment, the light-emitting element 102 has a first group of light-shielding layers 103bf and a second group of light-shielding layers 103bs, wherein the first group of light-shielding layers 103bf is adjacent to the light-emitting surface 102t of the light-emitting element 102, and the second set of light-shielding layers 103bs is adjacent to the photosensitive paper 200. When light is emitted from the light-emitting surface 102t, part of the light 45 can first be blocked by the first group of light-shielding layers 103bf. Before the light irradiates the photosensitive paper 200, the second group of light-shielding layers 103bs can block part of the light 55 again to further reduce the proportion of light that is not perpendicular to the photosensitive paper 200 irradiating the photosensitive paper 200 to control the width $W_3$ of the exposure area 35.

FIGS. 28-38 respectively illustrate cross-sectional views of light-shielding structures according to other embodiments of the present disclosure.

As shown in FIGS. 28-38, in one embodiment, the light-emitting hole 103h in the light-shielding layer 103b can be arranged in a specific shape to adjust the light-emitting direction. At first, a light-shielding film with a plurality of light-emitting holes 103h of specific shapes (such as part B in FIG. 28) can be formed at first by lamination, double-sided laser drilling, double-sided etching, or other suitable methods. The light-shielding film includes the materials of the light-shielding layer 103b and the barrier layer 103a. After the process as shown in FIG. 6, one or more light-shielding films are disposed on the light-emitting element 102 through compression molding, lamination, or other suitable methods, but the present disclosure is not limited thereto.

In one embodiment, the light-emitting hole 103h on each light-shielding film may have a top opening and a bottom opening of different widths. In an embodiment, in a cross-sectional view, the shape of the light-emitting hole 103h may be a bowing shape, a bullet shape, a bowl shape, etc., but the present disclosure is not limited thereto. For example, as illustrated in FIGS. 28-31, the light-shielding film is arranged according to the requirements for the light path, so that the light emitting from the light-emitting surface 102t of the light-emitting element 102 and sequentially passes through the wide part 103hw, the narrow part 103hn, the wide part 103hw, and the narrow part 103hn of the light-emitting hole 103h. In addition, the light-emitting hole 103h can also be arranged in other shapes according to the needs, and the light-shielding film can also be adjusted according to the needs so that the light-transmitting holes are combined in other ways, and are not limited to the aforementioned configuration of wide at the bottom and narrow at the top, as shown in FIGS. 32-38.

The present disclosure provides a light-emitting module and a method of forming the same, which can be applied to photosensitive arrays of cameras, printers, or other image output devices. The light-emitting module includes a substrate, a light-emitting element, and a light-shielding structure with a light-emitting hole. The light-emitting hole formed by photolithography, etching, or using precision processes, such as laser drilling, can accurately define the light-emitting position of the light-emitting element and reduce the inaccuracy in the light-emitting position caused by the deviation of the light-emitting element during the manufacturing process. For example, the second standard deviation of the second spacing between the light-emitting holes may be smaller than the first standard deviation of the first spacing between the light-emitting elements. In addition, in an embodiment of the present disclosure, by adjusting the aspect ratio of the light-emitting module, the size of the photosensitive area formed by the light-emitting element on the photosensitive paper can be accurately controlled, thereby improving the resolution of light-emitting modules used in photosensitive arrays.

Although several preferred embodiments are disclosed in the present disclosure, they are not intended to limit the present disclosure. Those having ordinary knowledge in the art to which the present disclosure belongs should also understand that such equivalent structures are not inconsistent with the scope of the present disclosure and that they can make various changes, substitutions, and replacements without violating the spirit and scope of the present disclosure. Therefore, the scope of protection of the present disclosure is defined by the scope of the claim attached hereto.

## Claims

**1.** A light-emitting module (10), comprising:

a substrate (101);
n number of light-emitting elements (102) disposed on the substrate (101) and having n-1 number of first intervals (Pi), wherein the n-1 number of first intervals (Pi) have a first standard deviation (SD1), any one of the n-1 number of first intervals ($P_1$) is a horizontal distance between two adjacent light-emitting elements (102) among the n number of light-emitting elements, and n is greater than or equal to 3; and
a light-shielding structure (103) disposed on the n number of light-emitting elements (102) and having n number of light-emitting holes (103h), wherein each of the n number of light-emitting holes (103h) corresponds to each of the n number of light-emitting elements (102), the n number of light-emitting elements (102) have n-1 number of second intervals ($S_i$), the n-1 number of second intervals ($S_i$) have a second standard deviation (SD2), and any one of the n-1 number of second intervals ($S_i$) is a horizontal distance between two adjacent light-emitting holes (103h) of the n number of light-emitting holes (103h),
wherein the first standard deviation (SD1) is greater than the second standard deviation (SD2).

**2.** The light-emitting module as claimed in claim 1, wherein the light-shielding structure (103) comprises:

a barrier layer (103a) disposed between the n number of light-emitting elements (102); and
a light-shielding layer (103b) disposed above the barrier layer (103a).

**3.** The light-emitting module as claimed in claim 2, wherein the light-shielding structure (103) further comprises an interposer layer (103c) disposed between the barrier layer (103a) and the light-shielding layer (103b).

**4.** The light-emitting module as claimed in any one of the preceding claims, wherein the light-shielding structure (103) has a concave portion, and the concave portion recesses downwardly between the two adjacent light-emitting elements (102).

**5.** The light-emitting module as claimed in any one of the preceding claims, further comprising a transparent substrate (104) disposed on the light-shielding structure (103), wherein the transparent substrate (104) comprises a plurality of optical microstructures (104a) disposed above the n number of light-emitting elements (102).

6. The light-emitting module as claimed in any one of the preceding claims, further comprising a transparent substrate (104) disposed on the light-shielding structure (103), wherein the transparent substrate (104) comprises a lens (104b) below a lower surface of the transparent substrate (104) and protruding toward at least one of the n number of light-emitting elements (102).

7. The light-emitting module as claimed in any one of the preceding claims, further comprising a wavelength conversion layer (105) disposed within at least one of the light-emitting holes (103h).

8. The light-emitting module as claimed in any one of the preceding claims , further comprising a protective layer (106) disposed above the light-shielding structure (103).

9. The light-emitting module as claimed in any one of the preceding claims, wherein in a cross-sectional view, each of the two adjacent light-emitting elements (102) has a vertical center line, and the horizontal distance between the two adjacent light-emitting elements (102) is the horizontal distance between two vertical center lines.

10. The light-emitting module as claimed in any one of the preceding claims, wherein a width of any one of the n number of light-emitting holes (103h) is smaller than a width of any one of the n number of light-emitting elements.

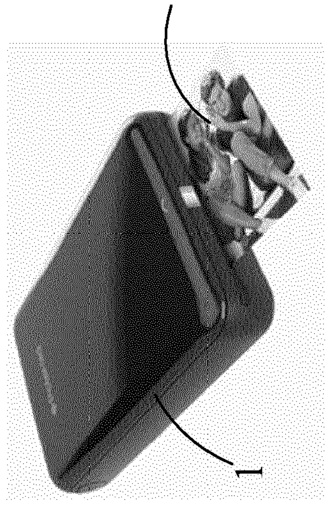


FIG. 1A

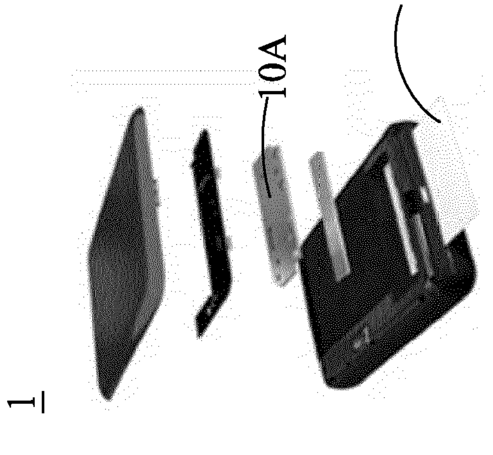


FIG. 1B

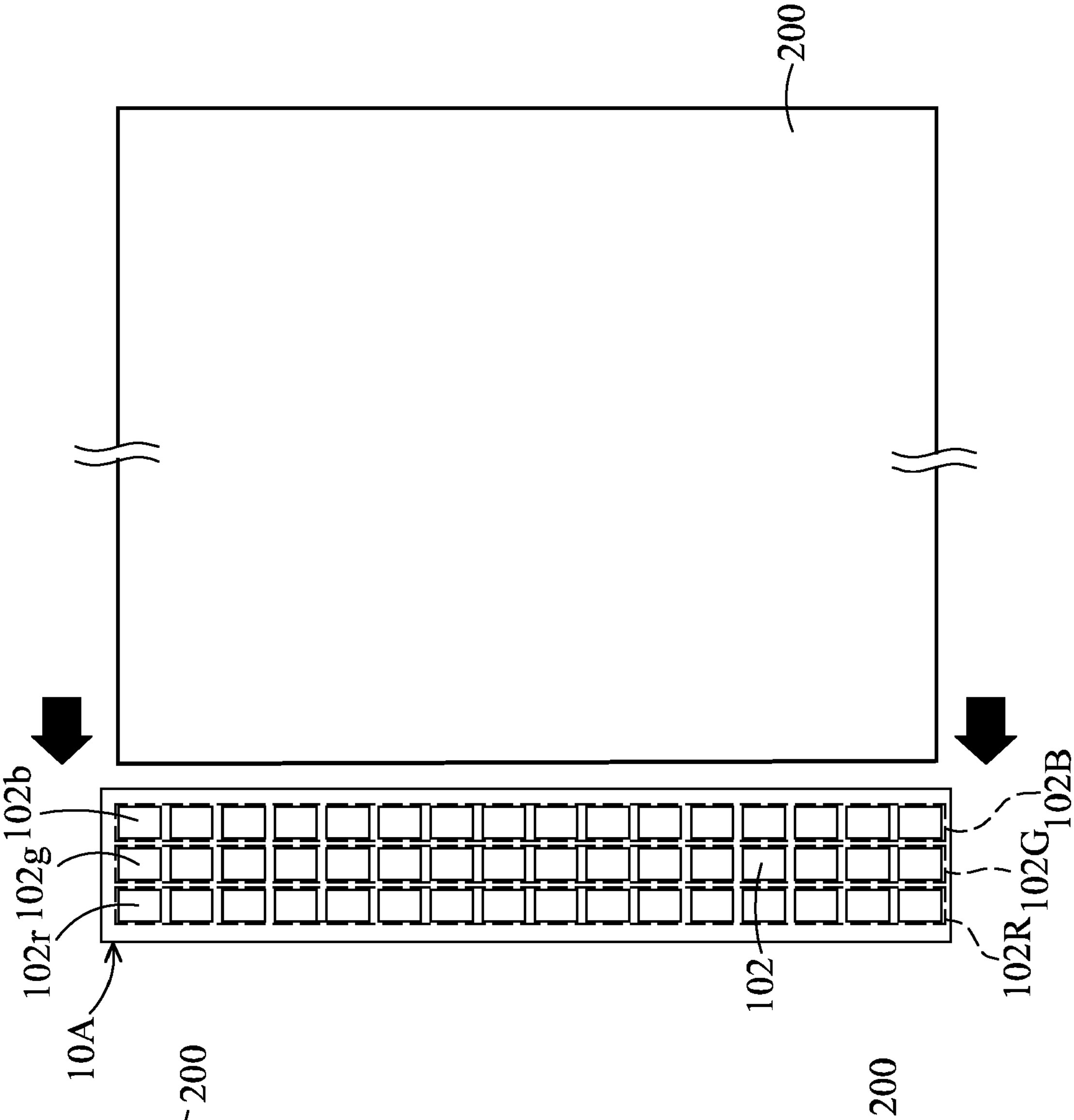


FIG. 1C

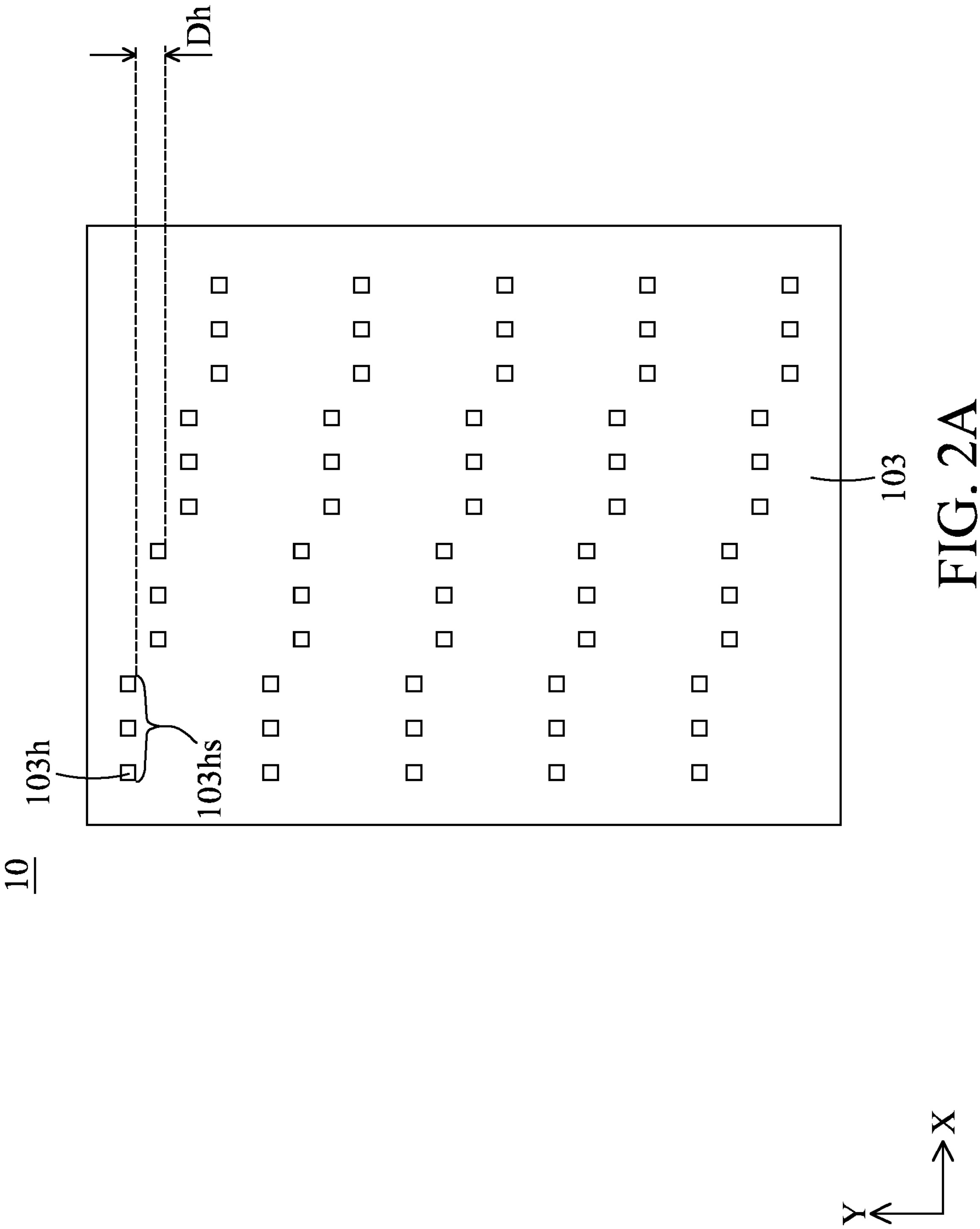


FIG. 2A

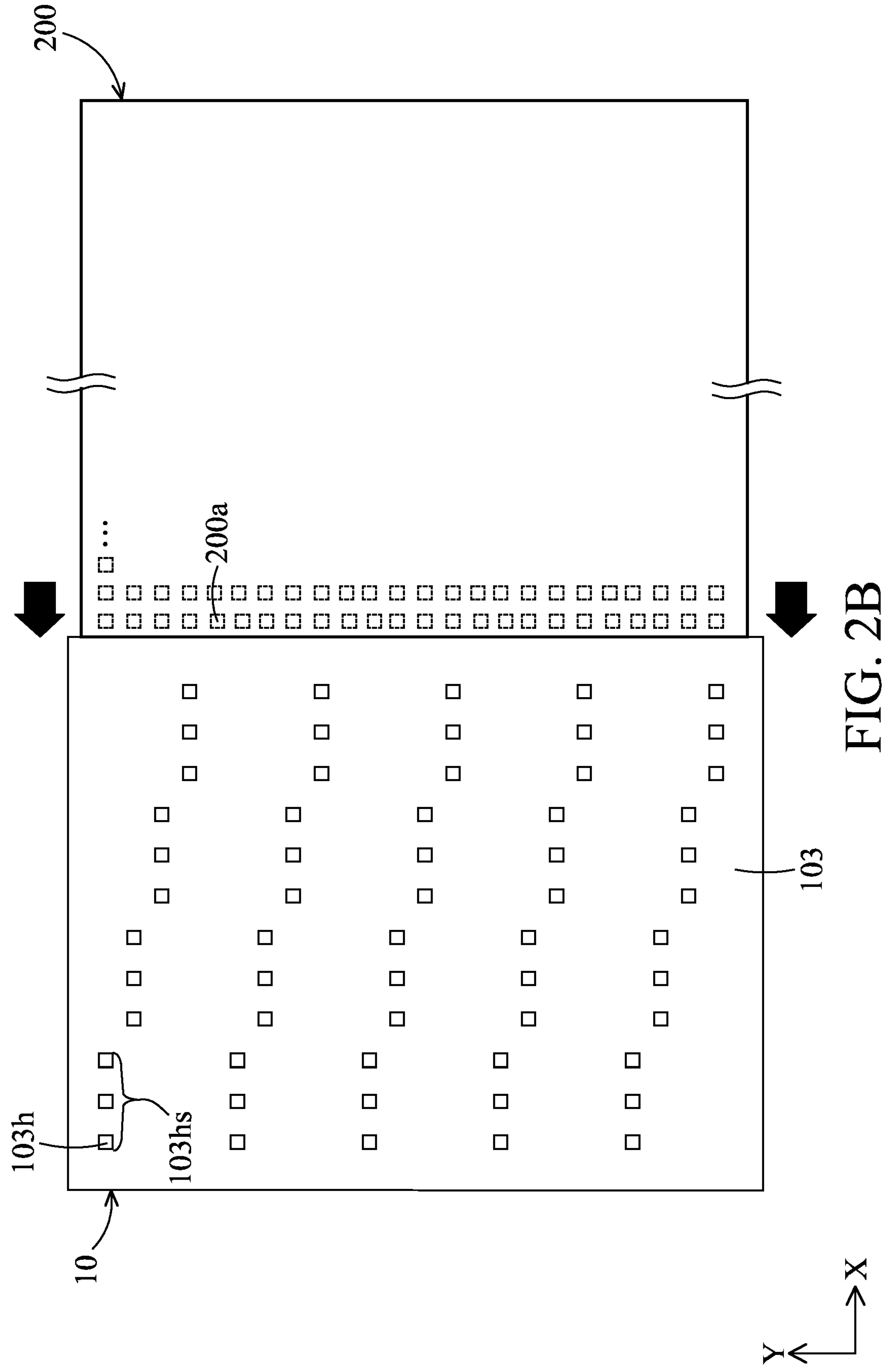


FIG. 2B

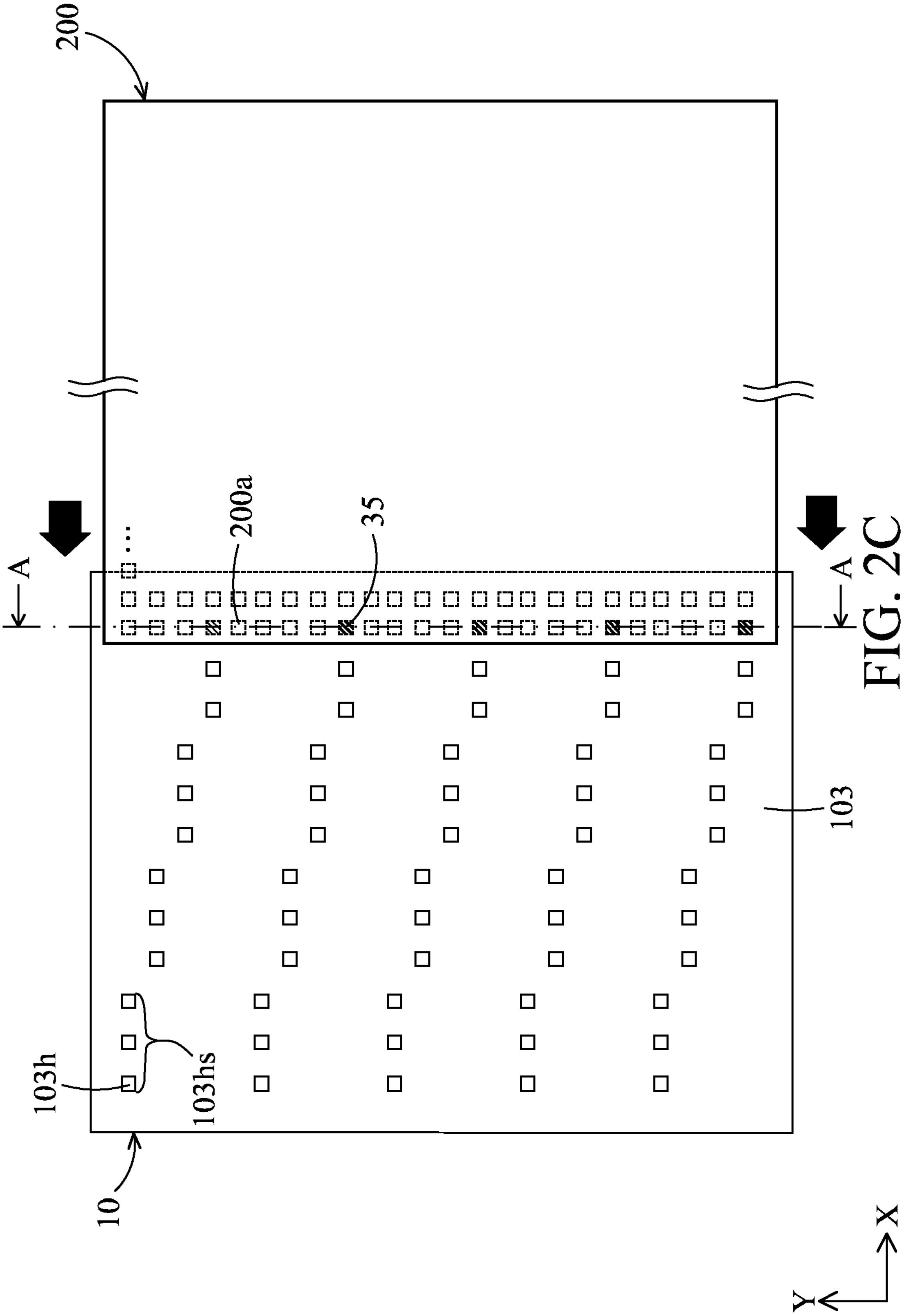


FIG. 2C

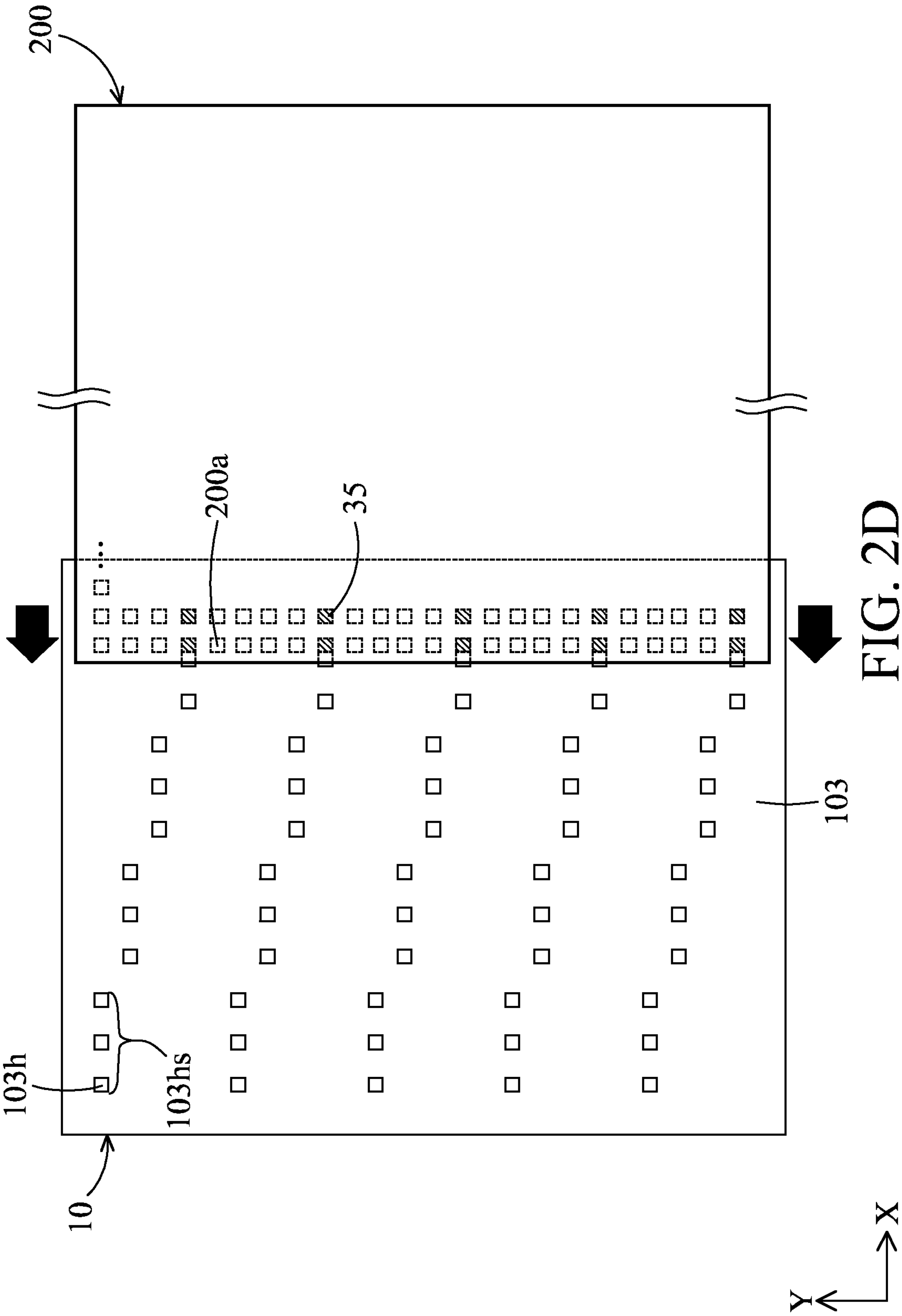


FIG. 2D

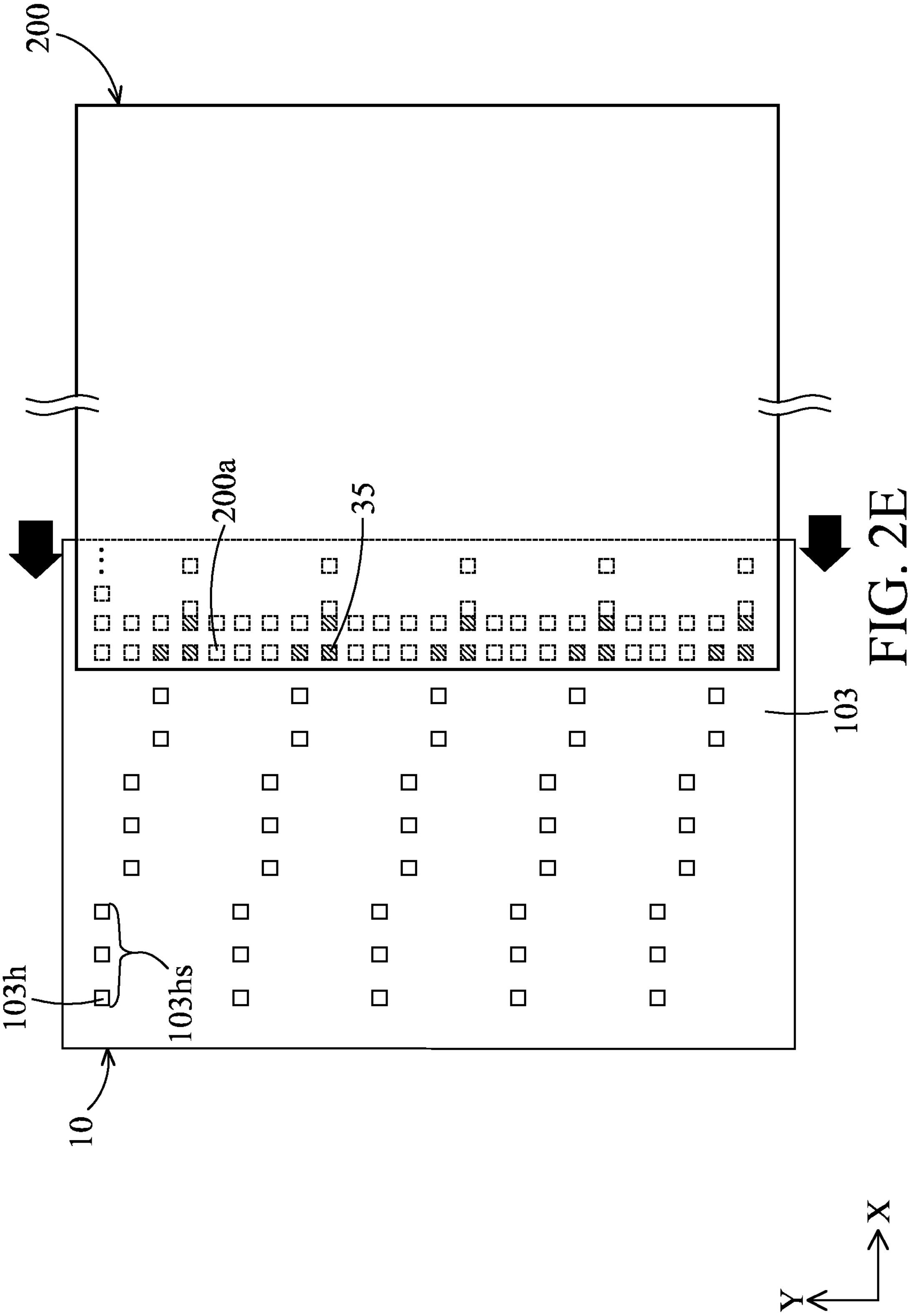


FIG. 2E

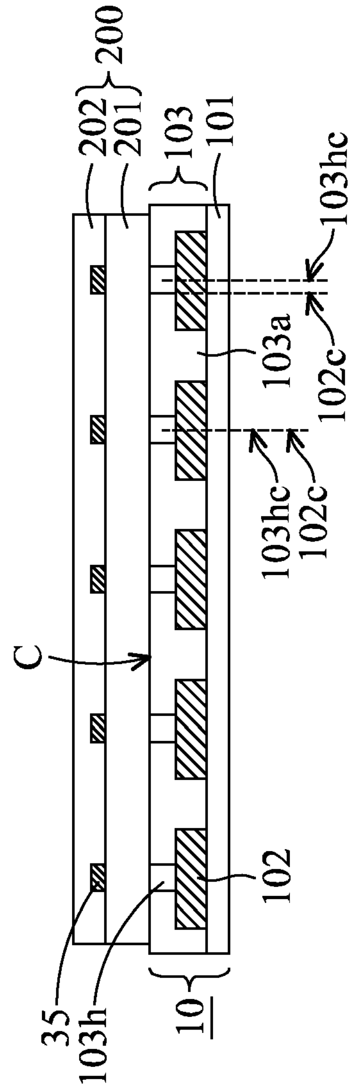


FIG. 3

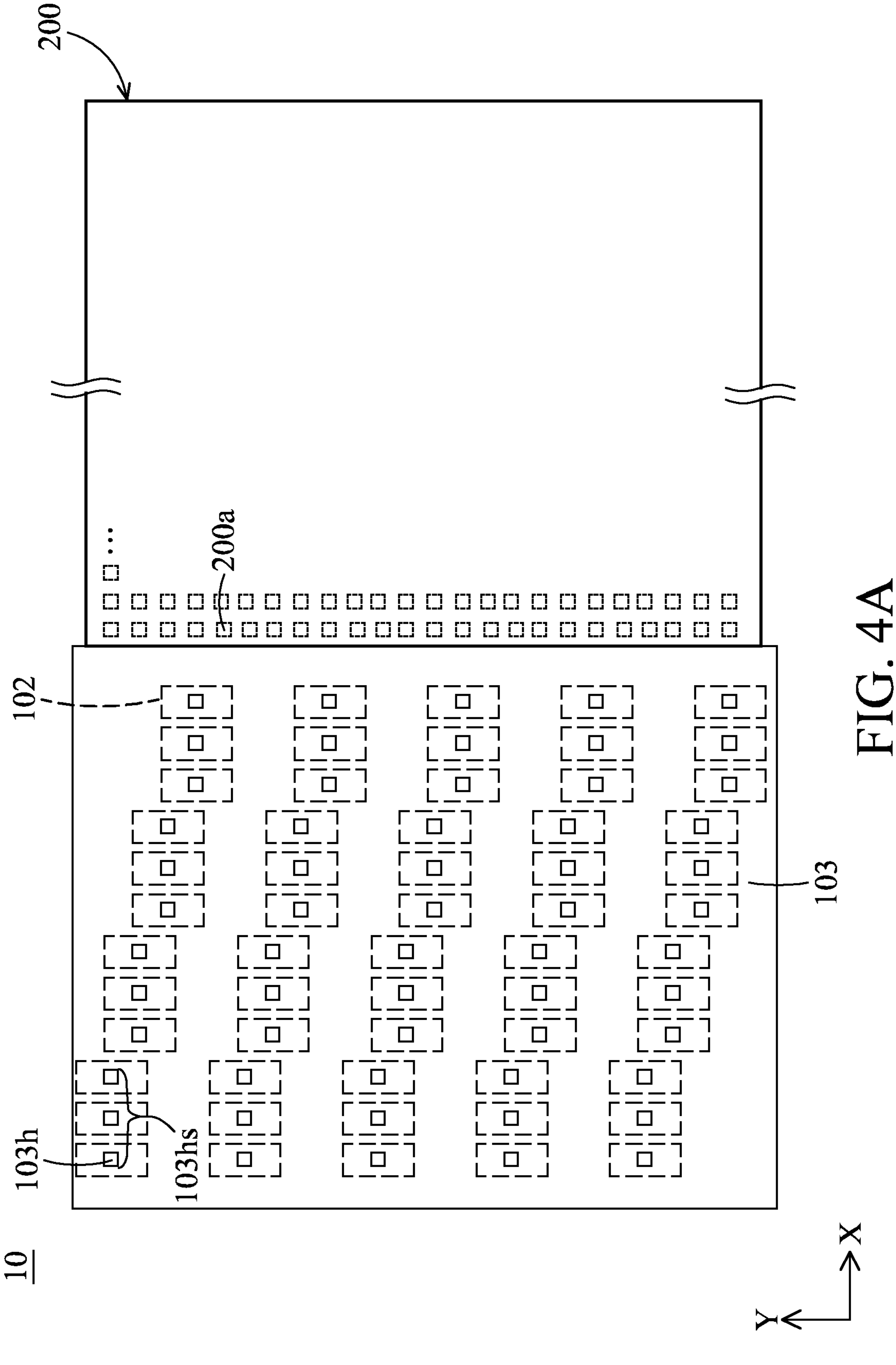


FIG. 4A

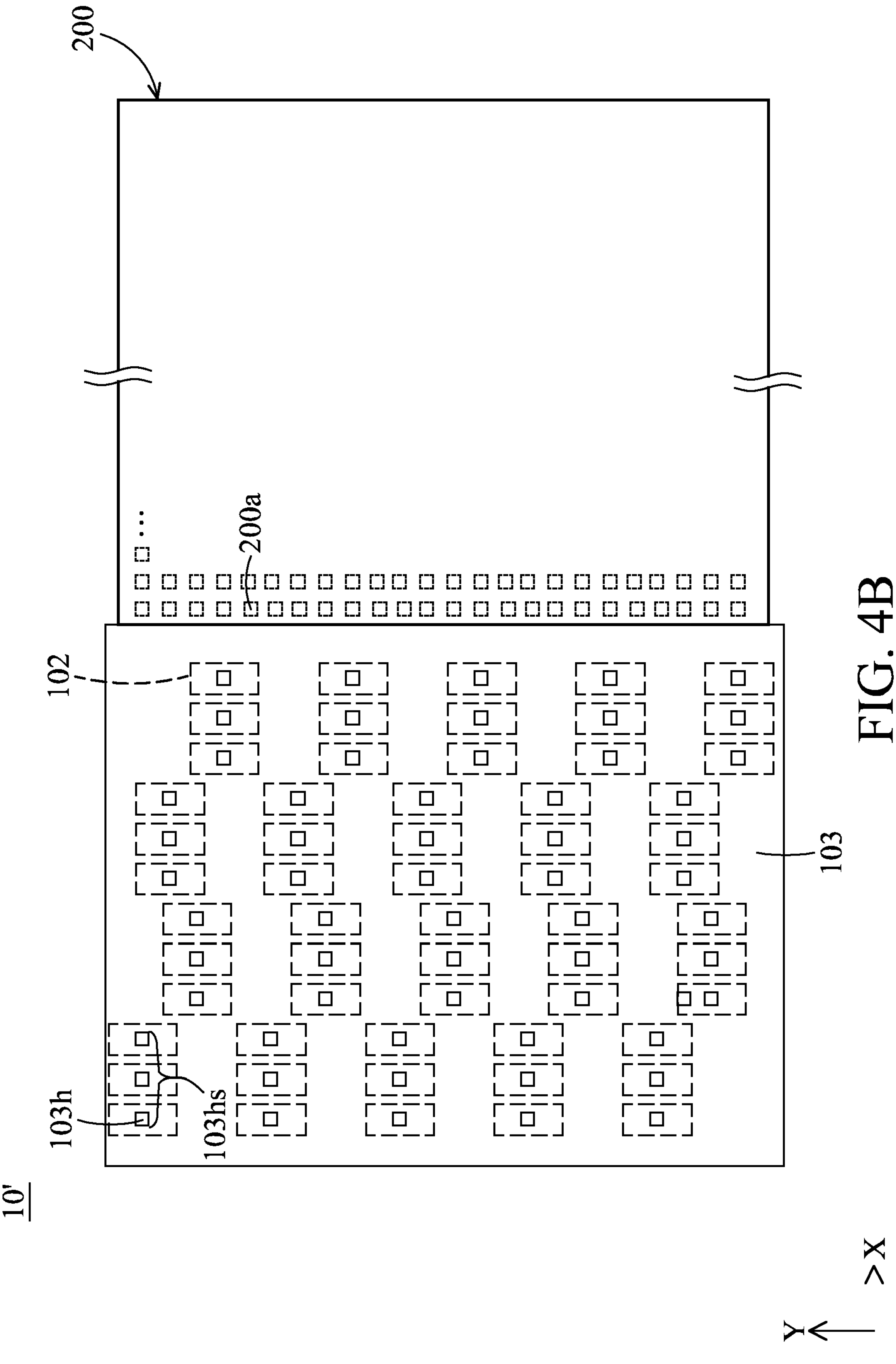


FIG. 4B

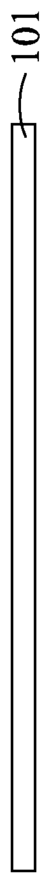


FIG. 5

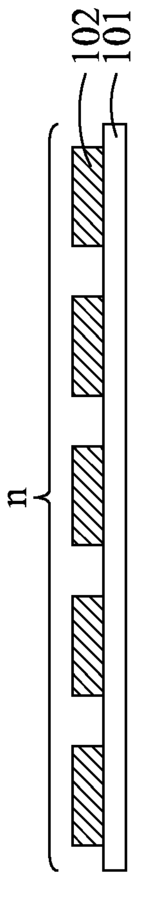


FIG. 6

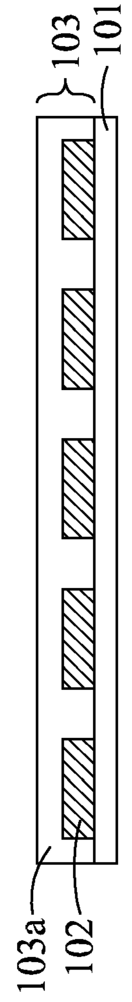


FIG. 7

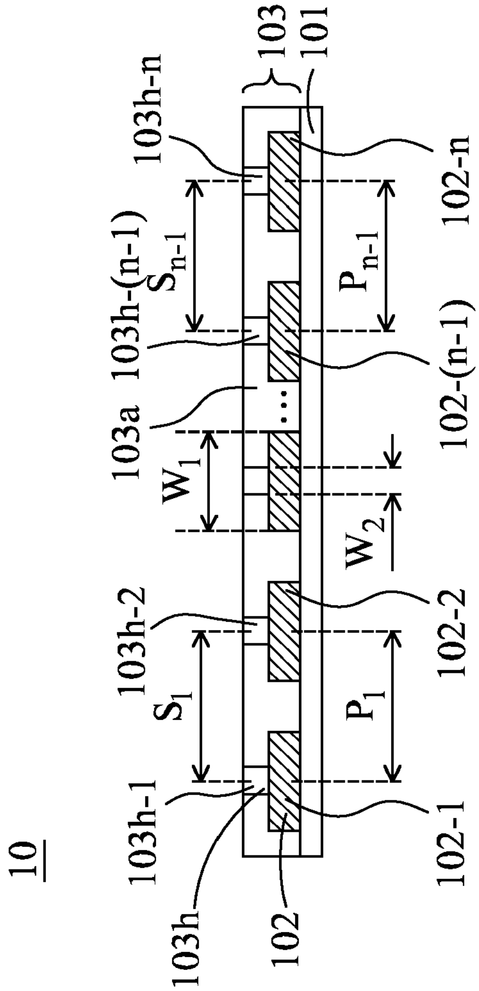


FIG. 8

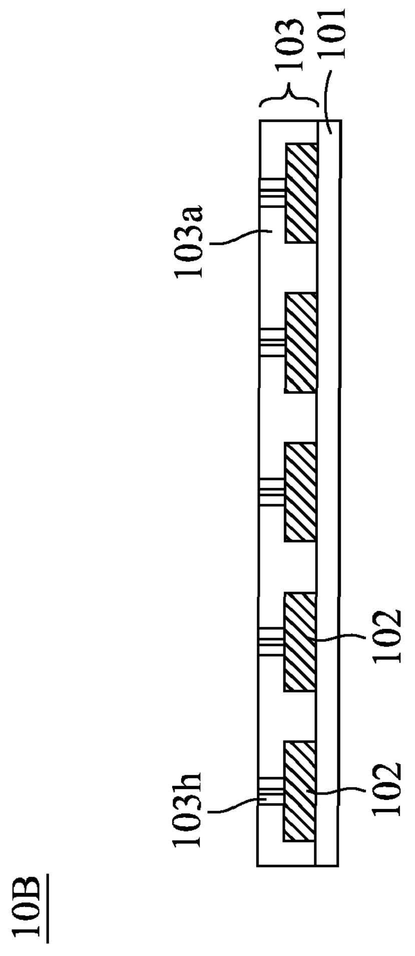


FIG. 9

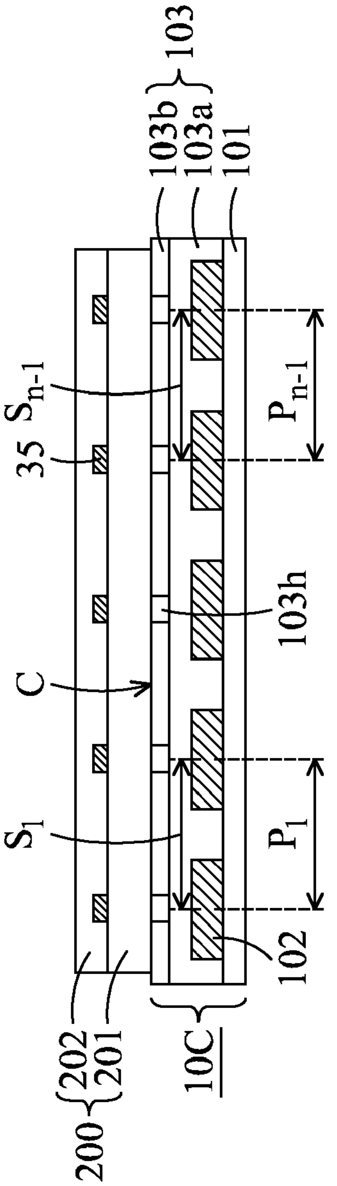


FIG. 10

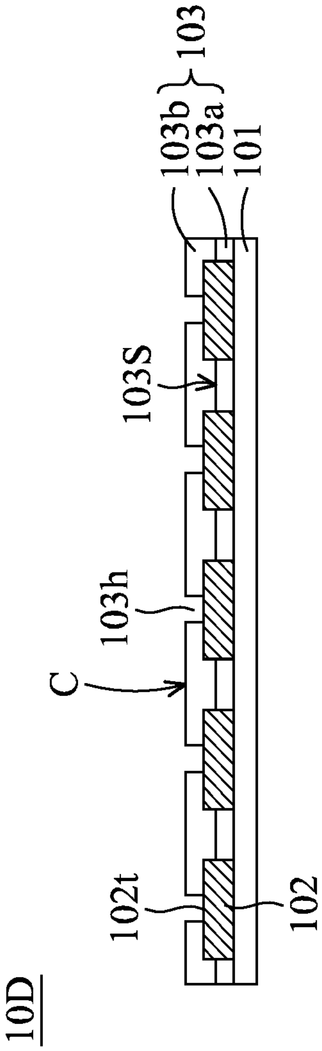


FIG. 11

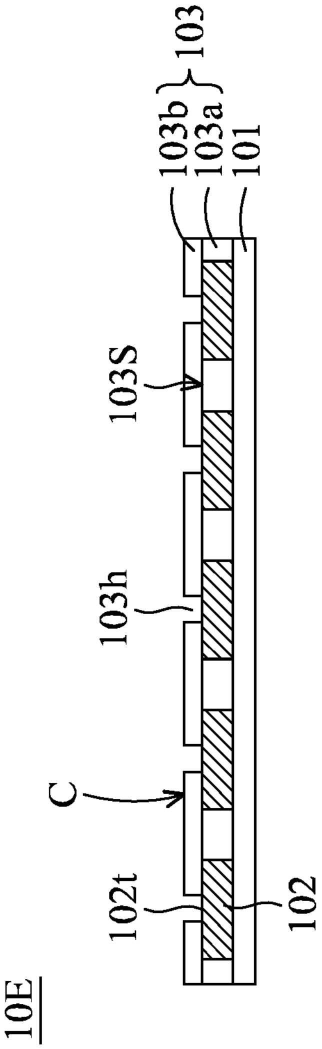


FIG. 12

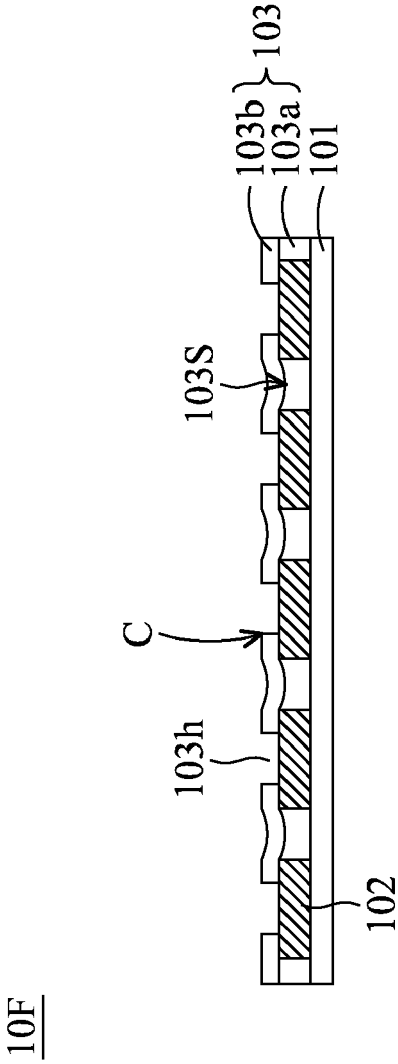


FIG. 13

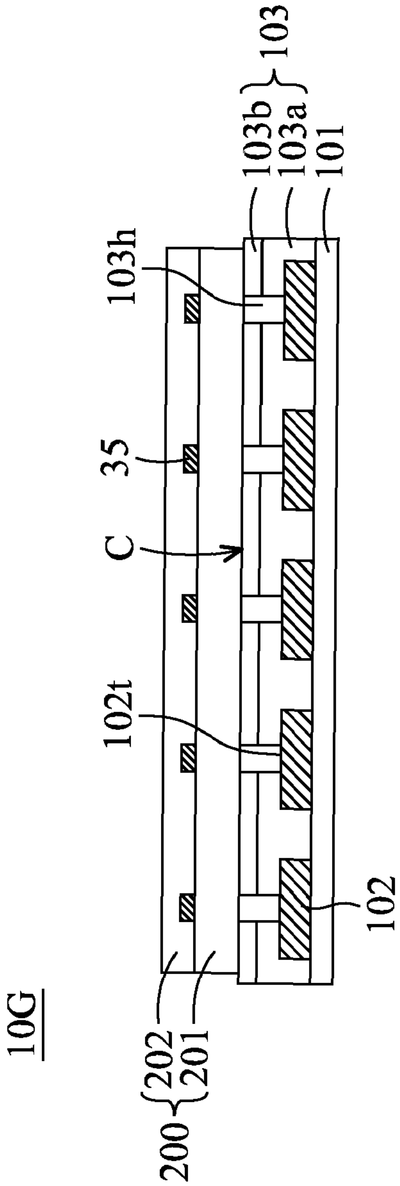


FIG. 14

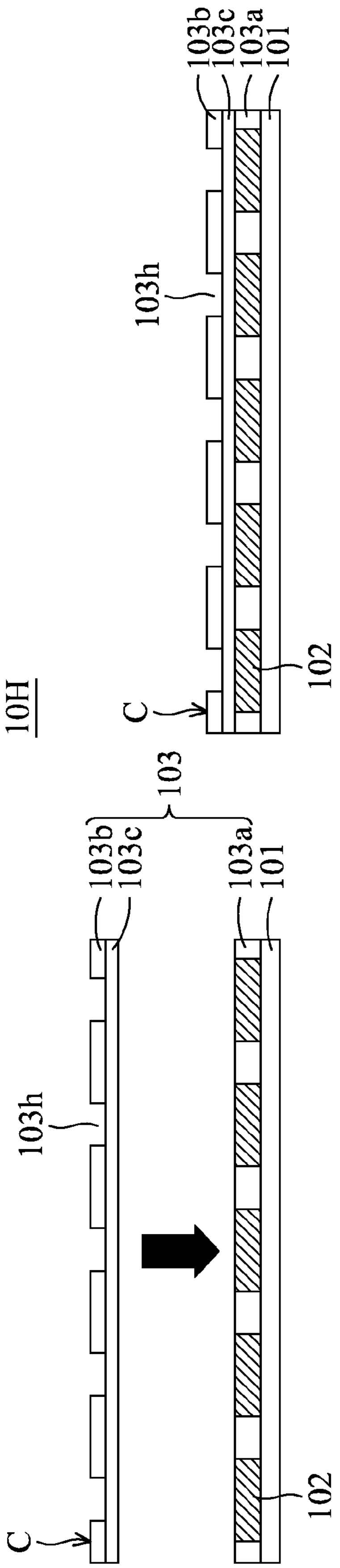


FIG. 15A

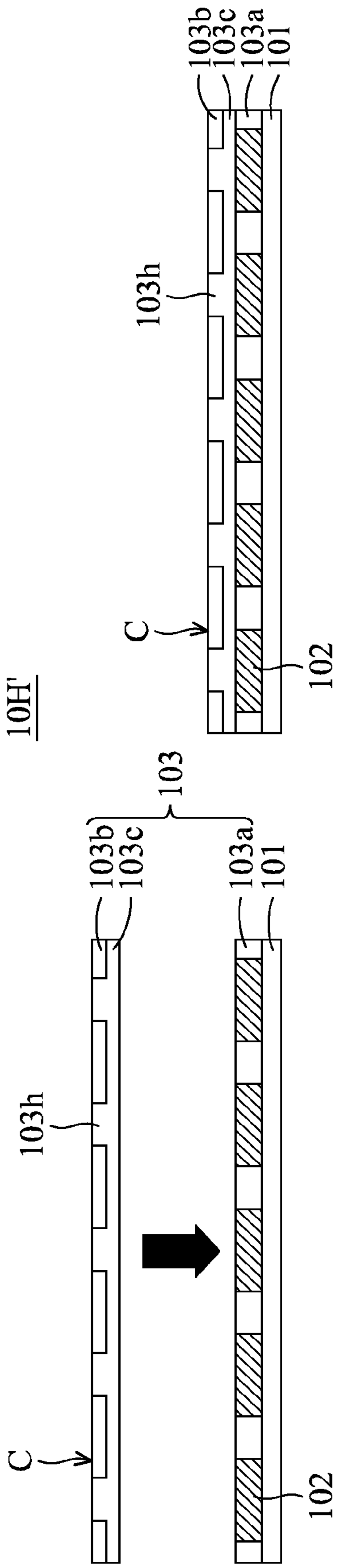


FIG. 15B

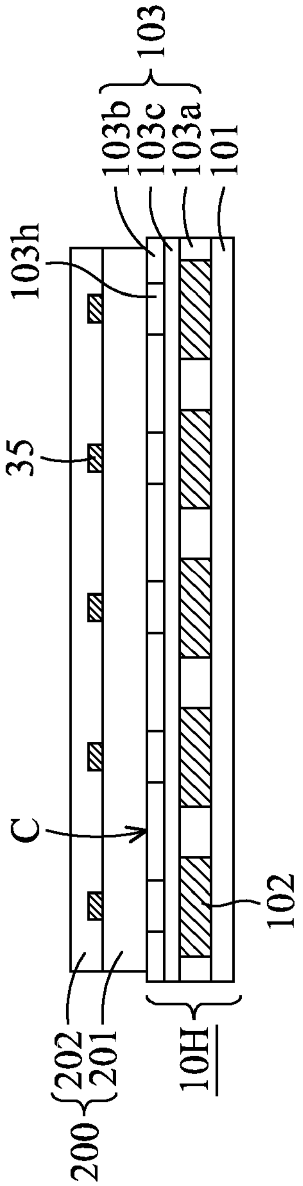
103h
35
C
103b
103c
103a
101
103
102
200
202
201
10H

FIG. 16

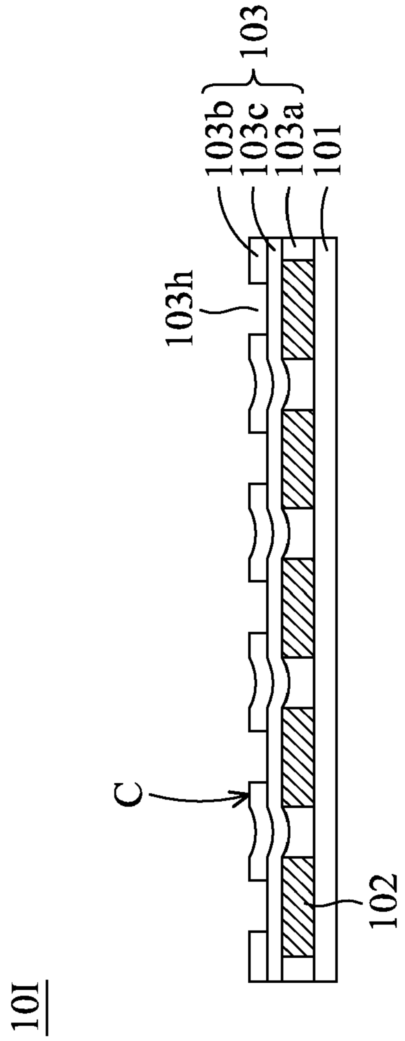
10I
103h
C
103b
103c
103a
101
103
102

FIG. 17

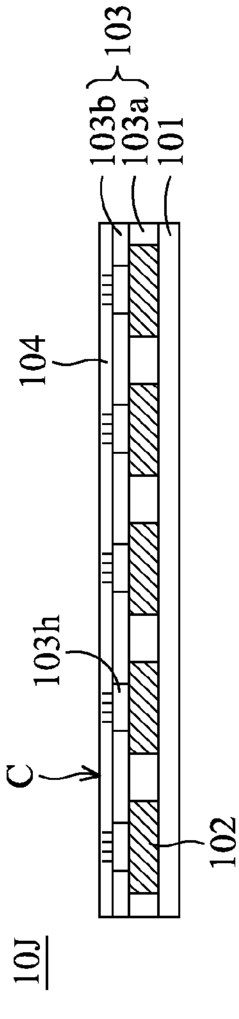


FIG. 18

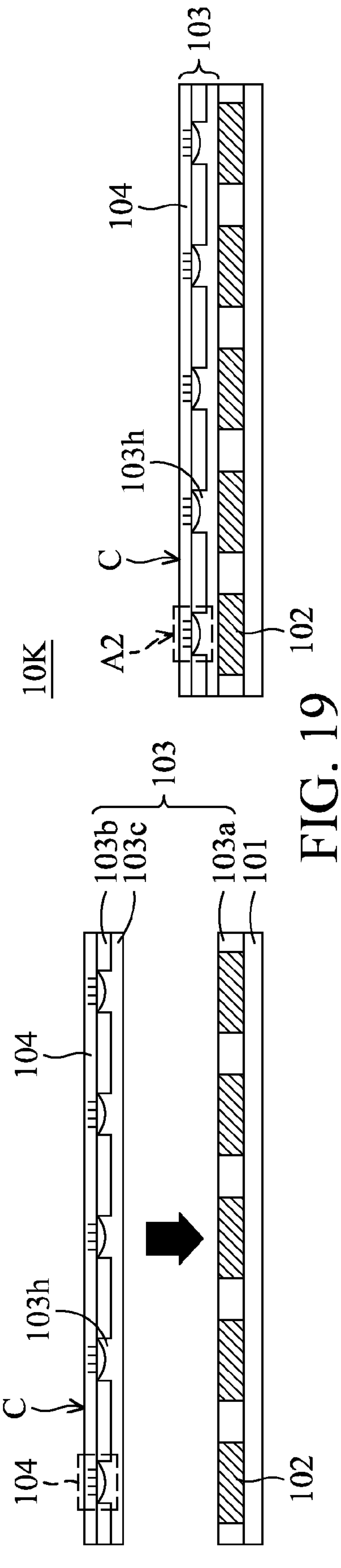


FIG. 19

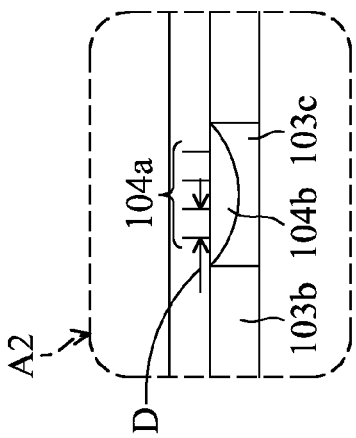


FIG. 20

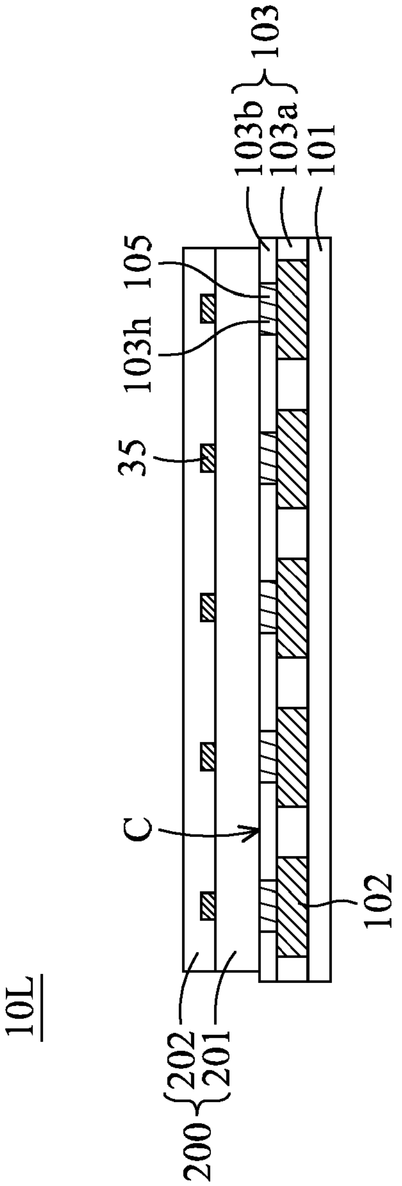
10L
200
202
201
C
35
103h
105
103b
103a
101
103
102

FIG. 21

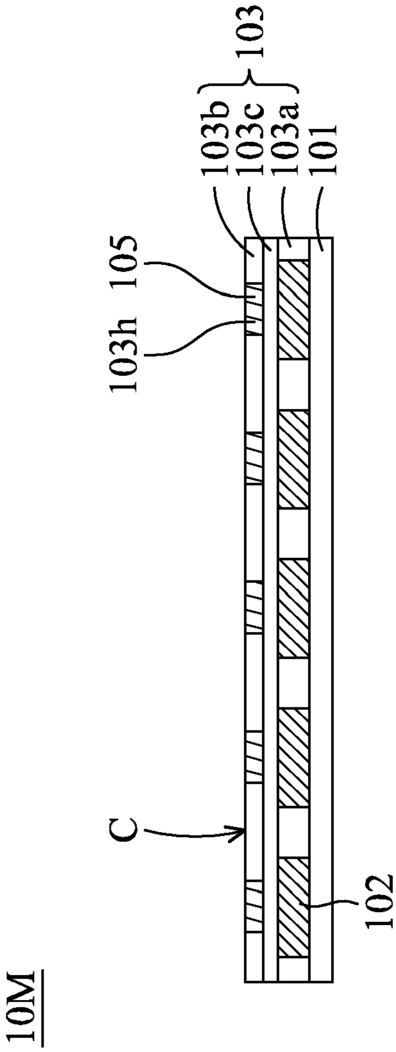
10M
C
103h
105
103b
103c
103a
101
103
102

FIG. 22

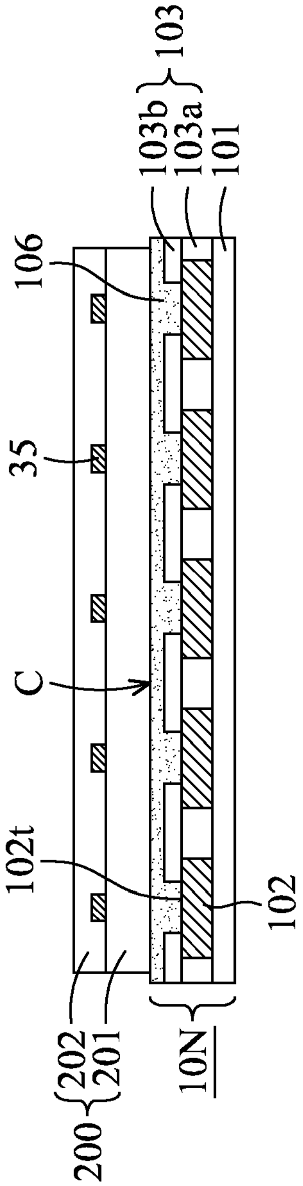
106
35
C
102t
102
103b
103a
103
101
200
202
201
10N

FIG. 23

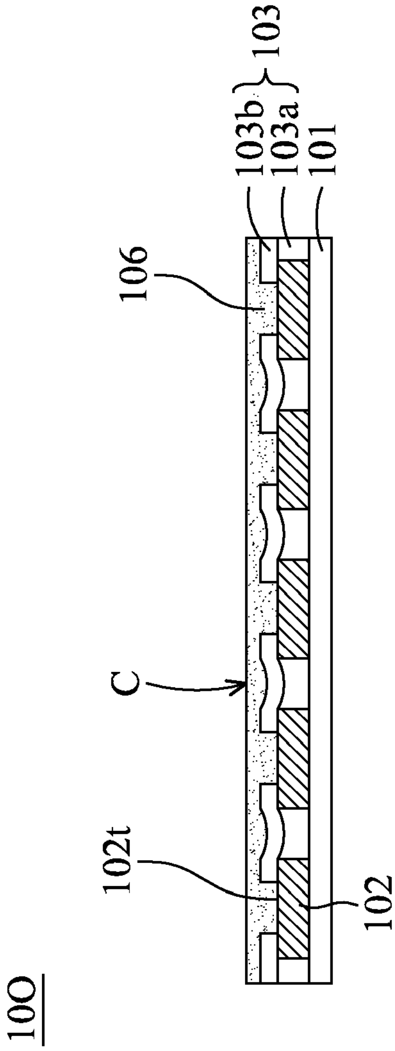
106
C
102t
102
103b
103a
103
101
10O

FIG. 24

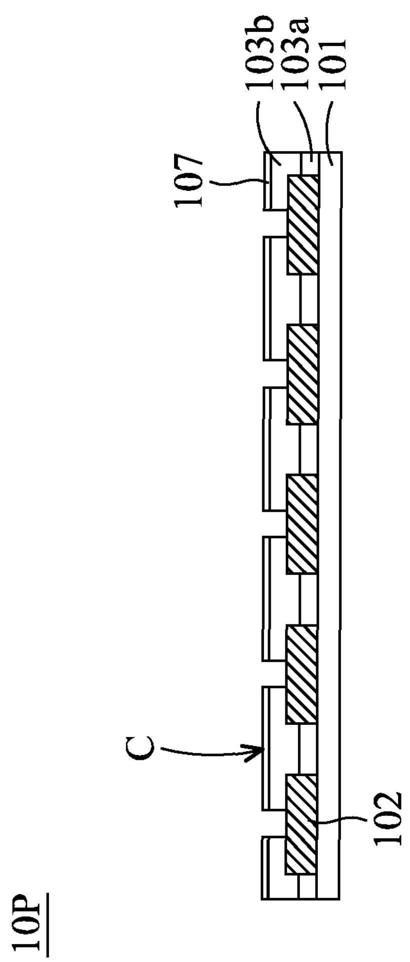


FIG. 25

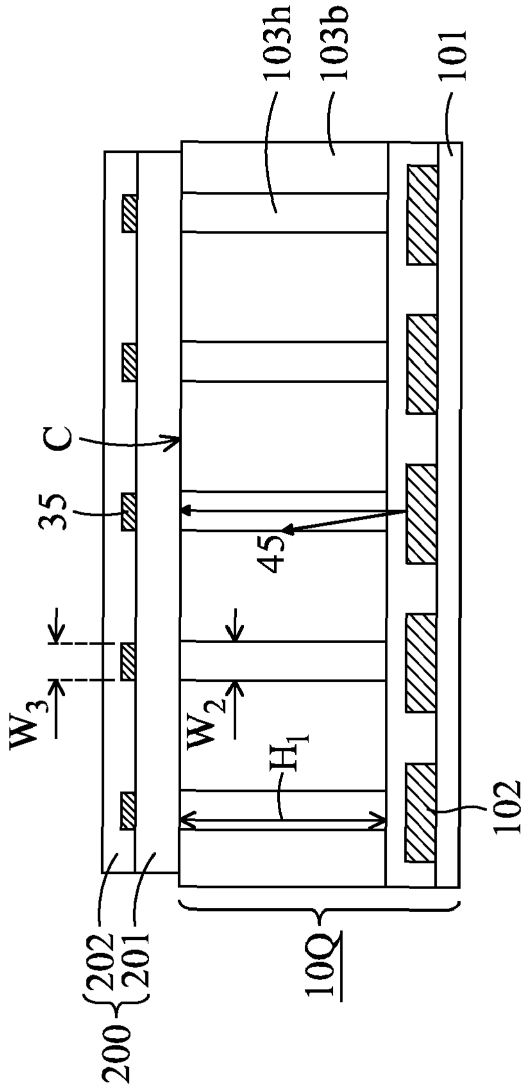


FIG. 26

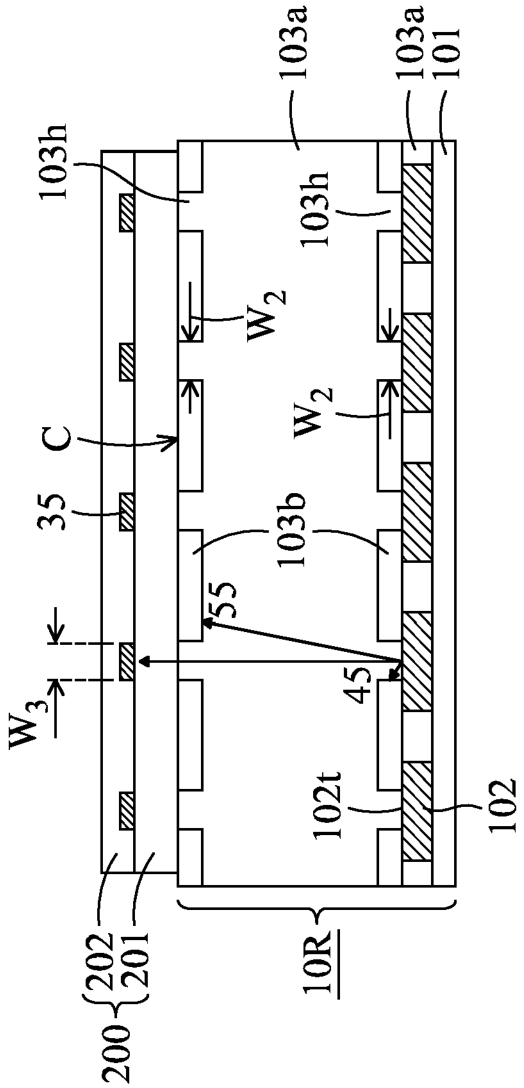
103h
103a
103h
103a
101
$W_2$
$W_2$
C
35
103b
55
$W_3$
45
102t
102
202
201
200
10R

FIG. 27

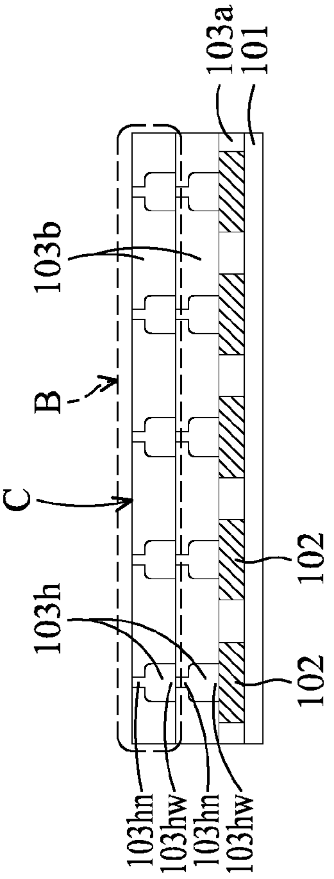


FIG. 28

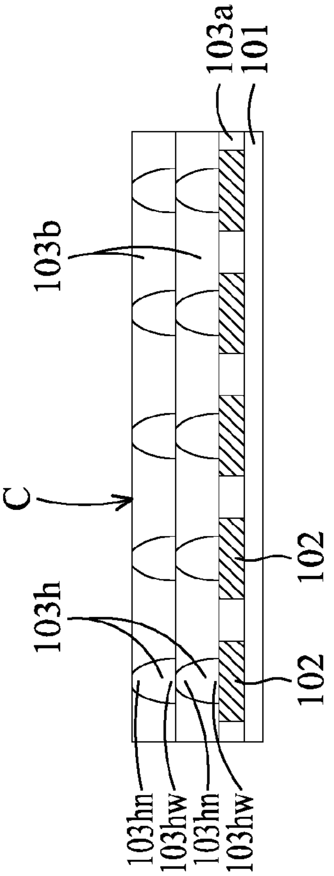


FIG. 29

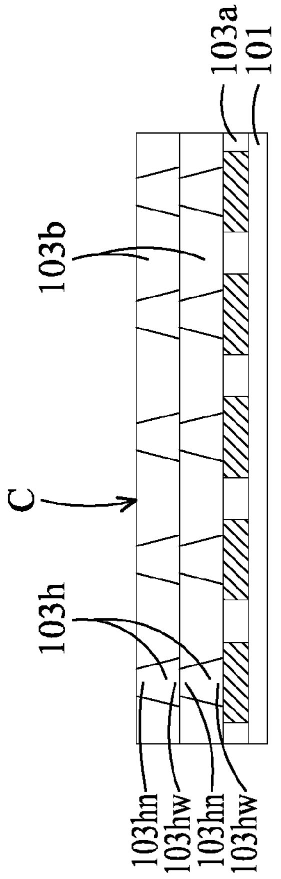


FIG. 30

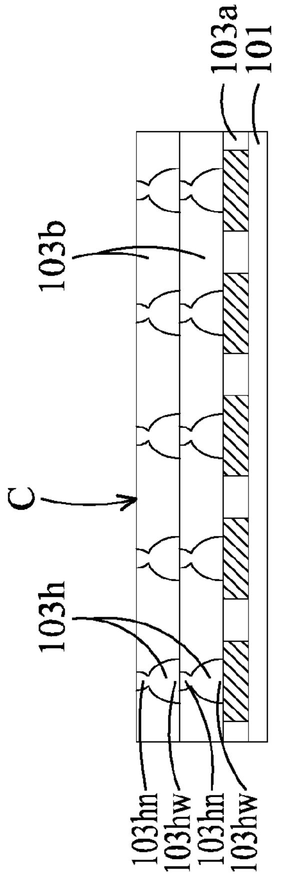


FIG. 31

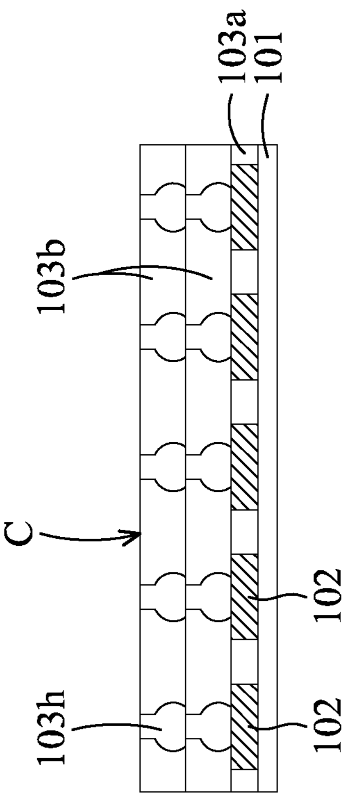


FIG. 32

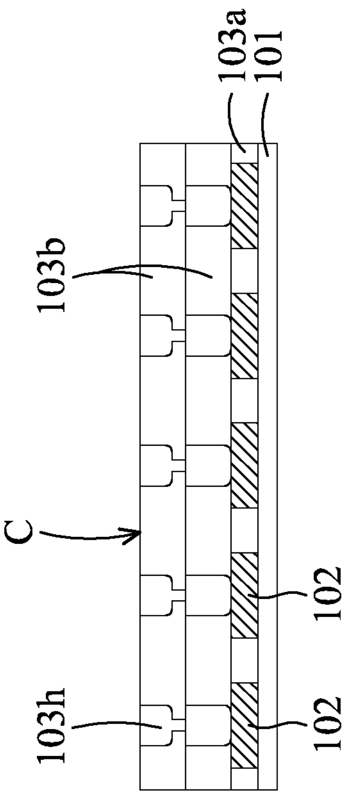


FIG. 33

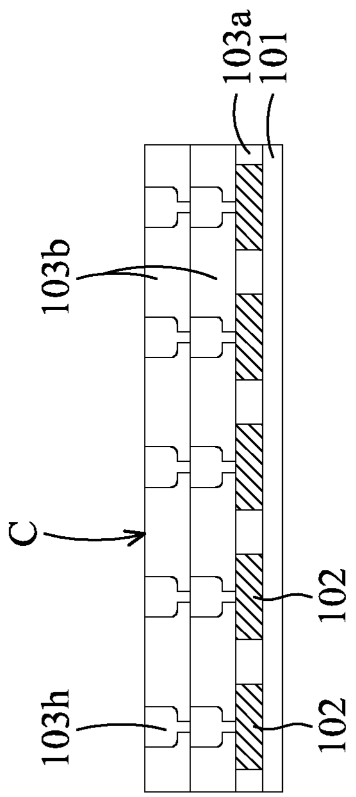


FIG. 34

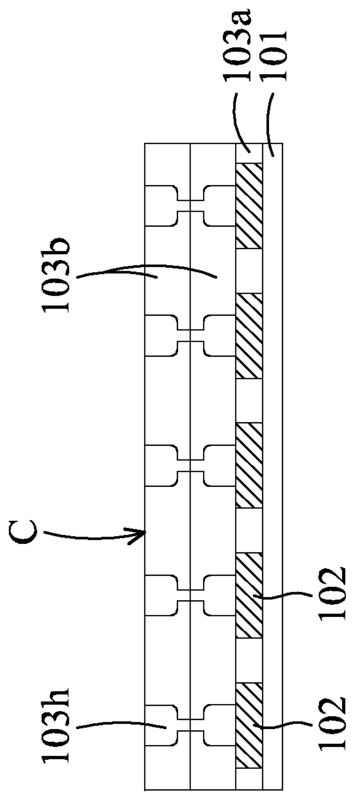


FIG. 35

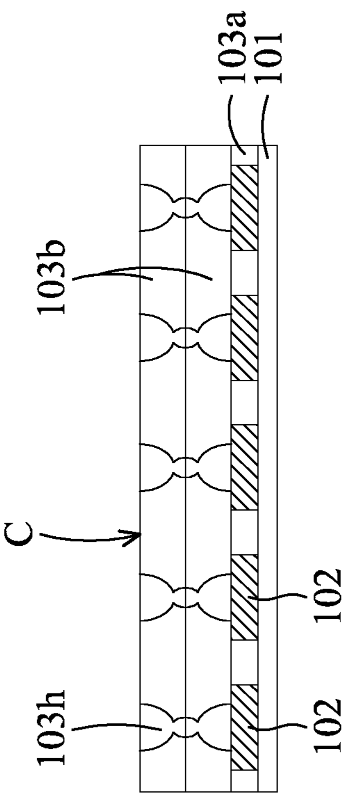


FIG. 37

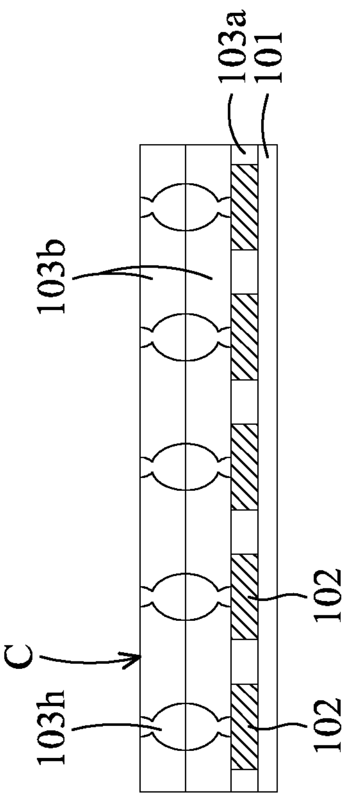


FIG. 36

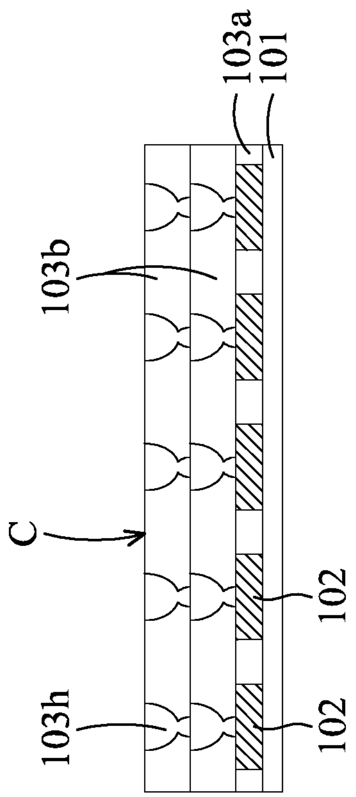


FIG. 38

Europäisches Patentamt
European Patent Office
Office européen des brevets

# EUROPEAN SEARCH REPORT

Application Number
EP 24 16 5478

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| X | US 2020/144465 A1 (LEE CHUNG HOON [KR]) 7 May 2020 (2020-05-07)<br>* paragraph [0062] - paragraph [0077] *<br>* figures 1,2,8 * | 1-10 | INV.<br>H01L25/075<br>H01L33/52<br>H01L33/54<br>H01L33/58 |
| A | US 2017/066168 A1 (LUDWIG KLAUS [DE] ET AL) 9 March 2017 (2017-03-09)<br>* figures 1,4,5,9,12-14 *<br>* paragraph [0119] - paragraph [0121] * | 1-10 | |
| A | US 2021/126043 A1 (LEE CHUNG HOON [KR] ET AL) 29 April 2021 (2021-04-29)<br>* figure 1D *<br>* paragraph [0090] * | 1-10 | |
| A | US 2020/350295 A1 (HU SHUN-YUAN [TW] ET AL) 5 November 2020 (2020-11-05)<br>* paragraph [0052] - paragraph [0054]; figures 5A, 5B * | 1-10 | |

TECHNICAL FIELDS SEARCHED (IPC)

H01L

The present search report has been drawn up for all claims

1

| Place of search | Date of completion of the search | Examiner |
|---|---|---|
| The Hague | 4 July 2024 | But, Gabriela-Ileana |

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons

& : member of the same patent family, corresponding document

EPO FORM 1503 03.82 (P04C01)

# ANNEX TO THE EUROPEAN SEARCH REPORT ON EUROPEAN PATENT APPLICATION NO.

EP 24 16 5478

This annex lists the patent family members relating to the patent documents cited in the above-mentioned European search report.
The members are as contained in the European Patent Office EDP file on
The European Patent Office is in no way liable for these particulars which are merely given for the purpose of information.

04-07-2024

| Patent document cited in search report | Publication date | Patent family member(s) | Publication date |
|---|---|---|---|
| US 2020144465 A1 | 07-05-2020 | BR 112021008899 A2 | 10-08-2021 |
| | | CN 112997329 A | 18-06-2021 |
| | | CN 210837758 U | 23-06-2020 |
| | | EP 3879586 A1 | 15-09-2021 |
| | | JP 2022506057 A | 17-01-2022 |
| | | KR 20210072008 A | 16-06-2021 |
| | | US 2020144465 A1 | 07-05-2020 |
| | | US 2023040991 A1 | 09-02-2023 |
| | | WO 2020096386 A1 | 14-05-2020 |
| US 2017066168 A1 | 09-03-2017 | CN 106660241 A | 10-05-2017 |
| | | DE 102014106585 A1 | 12-11-2015 |
| | | EP 3140097 A2 | 15-03-2017 |
| | | ES 2748425 T3 | 16-03-2020 |
| | | JP 6687219 B2 | 22-04-2020 |
| | | JP 2017522583 A | 10-08-2017 |
| | | KR 20170026353 A | 08-03-2017 |
| | | PL 3140097 T3 | 28-02-2020 |
| | | US 2017066168 A1 | 09-03-2017 |
| | | WO 2015169890 A2 | 12-11-2015 |
| US 2021126043 A1 | 29-04-2021 | BR 112022008047 A2 | 12-07-2022 |
| | | CN 114616674 A | 10-06-2022 |
| | | CN 213782016 U | 23-07-2021 |
| | | EP 4024453 A1 | 06-07-2022 |
| | | JP 2023501923 A | 20-01-2023 |
| | | KR 20220091457 A | 30-06-2022 |
| | | US 2021126043 A1 | 29-04-2021 |
| | | US 2023053740 A1 | 23-02-2023 |
| | | US 2024120365 A1 | 11-04-2024 |
| | | WO 2021086026 A1 | 06-05-2021 |
| US 2020350295 A1 | 05-11-2020 | NONE | |

EPO FORM P0459

For more details about this annex : see Official Journal of the European Patent Office, No. 12/82

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

### Patent documents cited in the description


- TW 113105614
- US 63454268